# EUROPEAN PATENT SPECIFICATION

(11) **EP 0 845 931 B1**
(45) Date of publication and mention of the grant of the patent: **15.09.2004**
(21) Application number: 97309689.4
(22) Date of filing: 02.12.1997
(51) Int. Cl.: H05K 7/14

(54) **Control device**
Steuergerät
Dispositif de commande

(30) Priority: 02.12.1996 JP 33443696; 03.12.1996 JP 33626896; 06.12.1996 JP 34040796
(43) Date of publication of application: 03.06.1998
(73) Proprietor: OMRON CORPORATION, Kyoto-shi, Kyoto 616-8025 (JP)
(72) Inventor: Yamamoto, Hiroyuki, Ukyo-ku, Kyoto 616 (JP); Hishikawa, Ken, Ukyo-ku, Kyoto 616 (JP); Ogawa, Tadahiko, Ukyo-ku, Kyoto 616 (JP)
(74) Representative: Calderbank, Thomas Roger

(56) References cited:
- EP-A- 0 439 122
- DE-A- 4 402 001

## Description

This invention relates to a control device of a thin type, and more particularly to an improved control device construction such as a timer or the like which is mounted directly or through a DIN rail on a control panel.

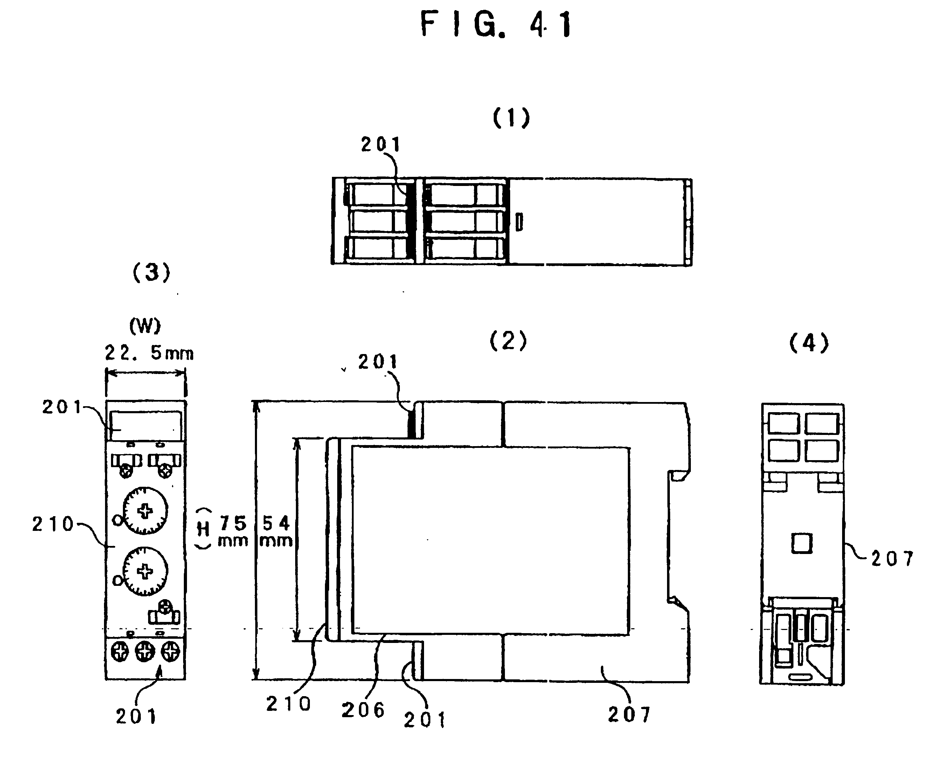

There is well known a control device construction in which a plurality of control components are conventionally mounted on a DIN rail in a side-by-side relationship, whereby its width (w) is regulated into 22.5 mm by a standard as shown in Fig. 41 at (3) and same dimensions are commonly employed by industry in silence as to its height and depth.

It is a key factor in such industrial background how to arrange a terminal block, an operational section and a display well within dimensions of a width (W) 22.5 mm × a height (H) 75 mm to improve its operability and visuality. It is also a key issue in view of a whole construction how easily such control components are assembled by reducing the number of their parts and the cost of their materials, so that each company in the industry makes its best efforts to achieve such two issues in well balance.

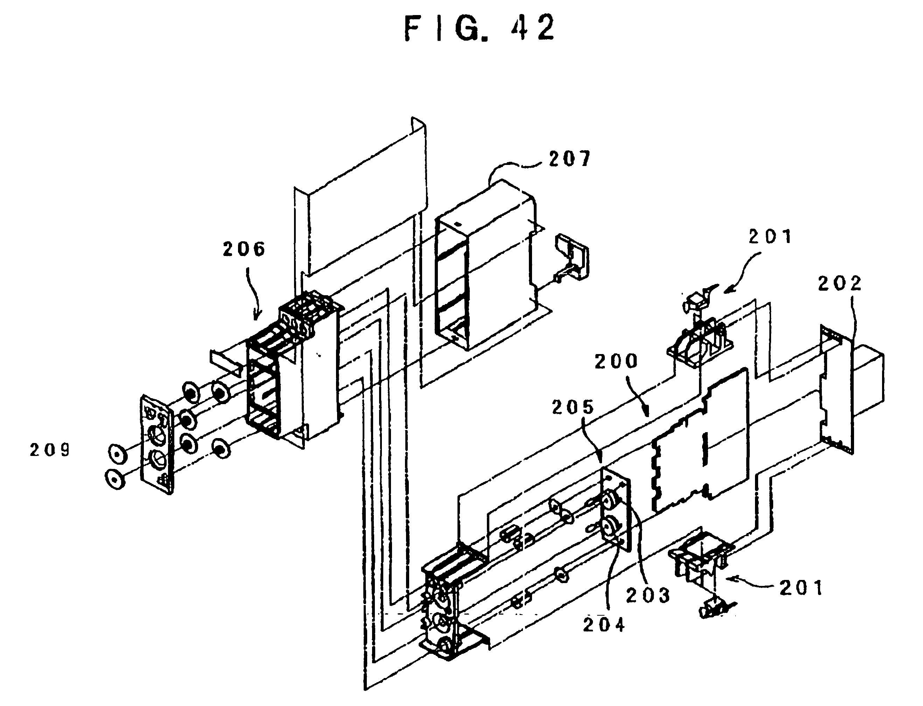

According to the conventional control device construction as shown in Figs. 41 and 42, a board 200 installed by main electronic parts is mounted by an output board 202 for connecting a terminal block 201 with the board 200, and an operational board 205 installed by a switch 203 and a variable resistor 204 which are set from the external, and the mounted board 200 is further housed from a horizontal direction by separable first and second housings 206 and 207.

The conventional control device construction has the following disadvantages (1), (2) and (3):
(1) The respective boards 200, 202 and 205 and the terminal are respectively assembled without the housings 206 and 207, so that they have to be assembled to be corrected or guided into the housings 206 and 207 by employing a jig.
(2) After all internal components are assembled into a single unit, the assembled unit is housed by the first and second housings 206 and 207 from front and back directions. Accordingly, an operation area in the front of the construction is decreased by a thickness of the front housing 206. In order to expand an operation section 210 to the maximum, the internal components on the boards 200, 202 and 205 are housed by the housings 206 and 207 to be mounted by operational knobs 209 from a front wall, resulting into difficulty in assembling to improve its operationality.
(3) After all internal components are assembled into a single unit, the assembled unit is housed by the first and second housings 206 and 207 from front and back directions.
Accordingly, increase of the number of terminals for improving the function decreases the size (the size of 54 mm in Fig. 41) of the operation section 210. Thus, the increase of function performed by increase of the number of terminals cannot be accomplished together with the improvement of the operatinality.

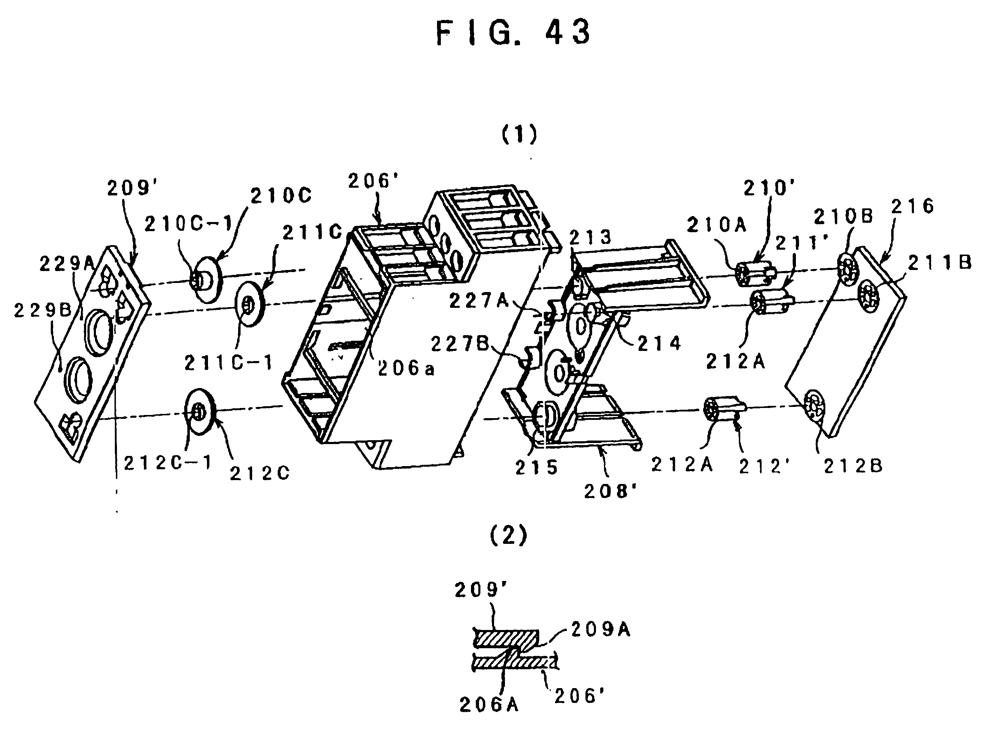

Fig. 43 shows another conventional switch construction which includes a first housing 206' housing a switch base member 208 therein, a front cover 209', first and second switches 210' and 211', a selector switch 212', and a printed circuit board 216 provided with electronic parts and a conductive pattern (not shown in drawings). The first switch 210' includes a switching body 210A, a slide element 210B as a press component, and a knob member 210C. The second switch 211' includes a switching body 211A and a knob member 211C, and the mode selecting switch 212' includes a switching body 212A and a knob member 212C. The switch base member 208 on its surface is provided witn first and second switch holding cylindrical portions 213 and 214 are penetrated by the first and second switches 210' and 211' for a rotational movement, and penetration sections of the switches 210' and 211' at their small diameter portions are mounted by the slide 210B and 211B. A mode switch holding cylindrical portion 215 is penetrated by the mode selecting switch 212' and a penetration section of the switch 212' at its small diameter portion is mounted by the slide element 211B.

The switch base member 208' mounted by the first and second switches 210' and 211' and the mode selecting switch 212' is fitted by the printed board 216 so that the slide elements 210B, 211B and 212B may be pressed to the conductive pattern, and inserted within the first housing 206' for engagement therewith so that front ends of the switches 210', 2111' and 212' projecting from a front wall of the switch base member 208' may be mounted by the knob members 210C, 211C and 212C, and a front cover 209' is fitted into a front opening 206a of the first housing 206' by engaging a hook 209A with an engagement projection 206A in a snap fit relationship as shown in Fig. 43 at (2) so that operational portions 210C-1, 211C-1 and 212C-1 of the knob members 210C, 211C and 212C may be projected forward of the front cover 209' to provide an operational portion of the control component.

The printed circuit board 206' is mounted by light emitting diodes (not shown) which penetrate through cutout portions 227A and 227B formed on the switch base member 208 to be positioned behind display windows 229A and 229B of the front cover 209'.

In this conventional control device construction, the first and second switches 210' and 211' and the mode select switch 212' respectively include switching bodies 210A, 211A and 212A and knob members 210C, 211C and 212C. Each of the switches consists of a pair of mold parts of the switching body 210A to 212A and the knob member 210C to 212C, so that the parts or components are expensive and the number of assembly steps is increased. A reason why each switch is composed of the pair of mold parts of the switching body and the knob member is to resolve such a disadvantage that the slide elements 210B to 212B as press components are pressed to contact the conductive pattern of the printed circuit board 216 to produce reaction forces and the front cover 209' snap fitted into the first housing 206' is bent if the reaction forces are received by the front cover 209' so that the slide elements 210B to 212B are not properly contacted with the conductive pattern of the board 216. The switch base member 208' is designed to receive the reaction forces to resolve such a disadvantage.

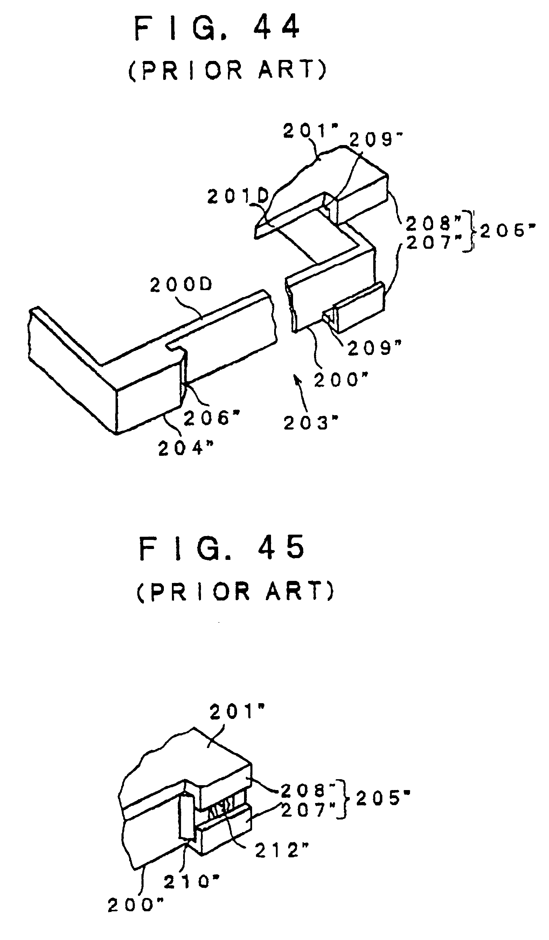

Still another conventional control component is shown in Figs. 44 and 45 which includes a first housing 200" and a second housing 201" serving as a cover, in which a rail engagement portion 203" is provided across the first and second housings 200" and 201".

The rail engagement portion 203" is provided with an upper rail hook member 204" and a lower rail hook member 205", in which the upper rail hook member 204" is formed with an external side of a rear wall 200D of the first housing 200" as a single unit providing an engagement hook directed downwardly (to a right hand side in Fig. 44). The lower rail hook member 205" includes one hook hold groove member 207" formed on a lower portion of an external side of the rear wall 200D of the first housing 200" and another hook hold groove member 208" formed on an external side of a rear wall 201D of the second housing 201", which the hook hold groove members 207" and 208" at their sides opposing each other are provided with hook hold grooves 209" along a vertical direction (horizontal direction in Fig. 45).

When the first housing 200" is coupled with the second housing 201", a rail hook member 210" is inserted into the hook hold grooves 209" to be fixed to the external sides of the rear walls 200D and 201D of the first and second housings 200" and 201" and be vertically slidable within an extent of flexure of a spring 212".

Thus the conventional control component may be mounted on a rail (not shown in drawings) by catching the rail with the upper and lower rail hook members 204" and 205" of the rail engagement portion 203.

In the control device mount construction, the one hook hold groove member 207" of the lower rail hook member 205" is formed on the lower portion of an external side of the rear wall 200D of the first housing 200", and another hook hold groove member 208" is formed on an external side of a rear wall 201D of the second housing 201", in which the rail engagement porton 203" is disposed across the first and second housings 200" and 201". When the first housing 200" is coupled with the second housing 201", a rail hook member 210" is inserted into the hook hold grooves 209" to be fixed to the external sides of the rear walls 200D and 201 D of the first and second housings 200" and 201", whereby in a vibration condition the rail engagement portion 203" is loosed and the control component is released from the rail member to fall.

EP-A-0439122 discloses an electrical circuit device in which parts are installed in a case forming a housing from a part install side to a open side, the part install side being formed by an opening in the end of the housing. Those parts include a terminal base forming a front module, and a board unit is mounted on the opens side to correct to he terminal base. A cover forming a second housing hooks to the case to cover the open side. Thus, this document corresponds to the pre-characterizing part of claim 1.

According to the present invention there is provided a control device comprising:
A first housing having a part install side at one side thereof and n open side at the other side thereof so that parts installation may be made from said part install side to said open side,
   a front module which is installed from said open side of said first housing to said part install side,
   a board unit which is mounted on said open side to be connected with said front module, and
   a second housing removably hooking to said open side of said first housing to cover said open side, said first housing being formed with a housing body having a part install side at one side thereof and an open side at the other side thereof;
wherein:
a front side of said housing body has a device unit mount section into which said front module is received;
said housing body has a plurality of terminal block sections which receive a corresponding plurality of terminal blocks which are installed from said open side of said first housing;
a rear side of said housing body has a rail engagement portion for removable engagement with a rail member;
said housing body has a plurality of support pillar engagement sections; and
said second housing has a plurality of engagement pillars removably engaged with said support pillar engagement sections.

This invention permits the assembly process of the device to be simplified so that the number of parts and assembly mechanic steps may be decreased and the control of intermediate assembly products may become easier, and the occupation areas by a front portion of a terminal block and by an operation portion are ensured in the maximum.

Each switch may be composed of a single mold component, whereby the part cost is reduced and the number of assembly steps also is reduced.

According to this construction, any soldering position jig required in a conventional board assembling is not necessary, the board unit may be assembled by installation into the housing, resulting into the reduction of the assembly process, though conventional internal assembly on a board is different process from installation of the assembly into the housing.

The front module may be assembled vertically against the first housing to install the front module from the open side of the housing to the part install side, so that the thickness of the housing does not decrease the operation display area in assembling though the conventional operation display area is decreased by the thickness of the housing. Though conventionally a switch section is assembled in assembling the board and a dial know is installed from a front wall after body assembling, the operation board and the respective components are assembled beforehand as one module, whereby the number of the parts and the assembly steps is decreased. The module configuration of the front module makes the intermediate assembly control easy.

The front module and the terminal block may be separately installed into the first housing, whereby such a conventional tradeoff relation between the occupation area by the front portion of the terminal block and the occupation area by the operation section viewed from the front is loosed. That is, this control device construction may have additional one array of a terminal block, which is reduced to the scale 51 mm against the scale 54 mm of a conventional operation section.

According to a second aspect of this invention, there is provided a control device according to the first aspect of this invention, in which the first housing is formed with a housing body having a part install side at one side thereof and an open side at other side thereof, a front side of the housing body including as a single unit a device unit mount section to be installed by the front module from the open side and a terminal block mount section to be installed to upper and lower portions of the device unit mount section by terminal blocks from the open side, a rear side of the housing body including a rail engagement portion to be removably engaged with a rail member, the housing body further including a plurality of support pillar engagement sections as a single unit, and the second housing includes a plurality of engagement pillars as a single unit therewith to be removably engaged with the support pillar engagement sections. This control device construction is assembled by inserting the front module to the device unit mount section and the terminal block to the terminal block mount section from the open side of the first housing, inserting the board unit to the open side of the first housing to connect the front module and the terminal block, and removably hooking the second housing to the open side of the first housing. Accordingly same advantages are available as those of the first aspect of this invention.

According to a third aspect of this invention there is provided a control device according to the second aspect of this invention in which the device unit mount section is composed by a side portion extending from the housing body of the first housing and hook means formed on upper and lower edges of the side portion for removably hooking the front module, and the terminal block mount section includes a hold wall construction having at its external side a lead wire derive portion and at its front side a terminal block expose window, a portion of the hold wall construction being provided with hook means for removably hooking the terminal block. This control device construction is assembled by inserting the front module to the device unit mount section of the first housing from the open side of the housing body to removably hook the front module by the hook means, inserting the terminal block to the terminal block mount section from the open side of the first housing to removably hook the terminal block by the hook means, inserting the board unit to the open side of the first housing to be connected with the front module and the terminal block, and removably hooking the second housing to the open side of the first housing. Accordingly same advantages are available as those of the first aspect of this invention.

According to a fourth aspect of this invention, there is provided a control device according to the third aspect of this invention, in which the terminal block mount section is so inclined that an axis passing a center of the terminal block expose window may be inclined against an axis passing a center of the device unit mount section of the housing body of the first housing to tilt the terminal block expose window outwardly. According to this construction, same advantages as those of the first and third aspects of this invention are expected, and the number of terminal blocks may be increased by mounting the terminal block to be tilted against the axis of the housing without decreasing the scale of the operation section.

According to a fifth aspect of this invention, there is provided a control device according to the third aspect of this invention, in which a support pillar portion is disposed on a portion of the hold wall construction of the terminal block mount section, the support pillar portion provides an engagement groove portion having an open portion passing through one end face of the support pillar portion and being open toward one wall side of the support pillar portion, and the housing body of the second housing is provided with an engagement portion to be inserted into the engagement groove portion.

According to this construction, same advantages as those of the first and third aspects of this invention are expected. Moreover, the engagement portion is inserted into the engagement groove portion of the support pillar portion when the second housing is mounted on the first housing wherein the engagement groove portion passes the end face of the support pillar portion and expands to both sides catching the open portion of the said engagement groove portion because of the open portion opened to one wall side of the support pillar portion, so that the engagement portion may be easily inserted into the engagement groove portion of the support pillar portion. Thus, the first and second housings may be firmly engaged even if there is a small torsion or positional shift in the mold of the first and second housings.

According to a sixth aspect of this invention, there is provided a control device according to the first aspect of this invention which includes a module mount section disposed on the first housing, a switch unit mounted on the module mount section in which a slide element disposed on the switch unit is pressed to contact a conductive pattern on a printed circuit board, and engagement means for removably engaging the switch unit with the module mount section. In this construction, the switch unit can be engaged with the module mount section by the engagement means, so that the switch construction components are not bent by the reaction force produced by pressing the slide element as the press component against the conductive pattern, whereby each of the switches is composed of a single mold component, the cost of the components is reduced and the number of assembly steps is also decreased.

According to a seventh aspect of this invention, there is provided a control device according the sixth aspect of this invention in which the switch unit is a front module wherein a switch and a mode select switch, in which a knob is formed on each switch main body of the switches as a single unit, penetrate through a switch base member for a rotational movement, the penetrating ends of the switches are mounted by slide elements, the switch base member is mounted by a front cover member so that the respective operation portions of the switches may penetrate through the front cover member to be exposed to the external, and the switch base member is mounted by the printed circuit board so that the slide element is pressed to contact the conductive pattern on the printed circuit board. This construction has same advantages as those of the construction of the sixth aspect of this invention, and further has an advantage that the switch construction is easily formed to a unit form.

According to an eighth aspect of this invention, there is provided a control device according to the sixth aspect of this invention in which the engagement means is so constructed that one engagement portion is respectively disposed on the module mount section of the first housing and on a position of the second housing opposing to the module mount section, and other engagement portion is disposed on the front module to be removably engaged with the one engagement portion. When the front module is mounted on the first and second housings (to the module mount section in case of the first housing), the other engagement portion of the front module is removably engaged with the one engagement portion so that the front cover may be free from any bent by the reaction force produced by pressing the slide element to the conductive pattern of the printed circuit board. This construction has same advantages as those of the construction of the sixth or seventh aspect of this invention.

According to a ninth aspect of this invention, there is provided a control device according to the seventh aspect of this invention in which an optical guide portion is formed on the switch base member, one end of the optical guide portion is inserted into a display window disposed on the front cover, and light projected from a light source disposed on the printed circuit board is exposed on the display window through the optical guide portion. This construction has same advantages as those of the construction of the sixth, seventh or eighth aspect of this invention, and such a further advantage that the display construction is simplified which is convenient to a unit form of the and the switch construction.

According to a tenth aspect of this invention, there is provided a control device according to the first aspect of this invention in which rail mounting means for mounting a control device on a rail member is disposed on one of the first and second housings. The rail mounting means for mounting the control device on the rail member is disposed one of the first and second housings, not across the first and second housings, whereby the rail mounting means is not loosed in a vibration condition so that any drop of the control device from the rail member may be prevented.

According to an eleventh aspect of this invention, there is provided a control device according to the tenth aspect of this invention in which the rail mounting means is composed of one rail hook portion disposed on an external surface of the first housing and having an engagement hook and other rail hook portion disposed on an external surface of the external surface of the first housing and having a rail hook member opposed to the engagement hook. The rail member is caught by the engagement hook of the one rail hook portion disposed on the external surface of the first housing and the rail hook member of the other rail hook portion disposed on the external surface of the first housing to mount the control device on the rail member, so that the rail mounting means is not loosed in a vibration condition so that any drop of the control device from the rail member may be prevented.

According to a twelfth aspect of this invention, there is provided a control device according to the eleventh aspect of this invention in which the one rail hook portion is disposed on the first housing as a single unit directing the engagement hook directed to the other rail hook portion, the other rail hook portion is composed by a pair of hook hold groove form portions disposed on the external surface of the first housing and hook hold grooves respectively formed on the opposing sides of the hook hold groove form portions, and the rail hook member is inserted into the hook hold grooves to hook a spring portion held by the rail hook member on the external surface of the first housing so that the rail hook member is mounted on the other rail hook portion within a bent extent of the spring portion for a movement. The respective hook hold groove form portions of the one rail hook portion are formed on the external surface of the first housing and the rail mounting means is not disposed across the first and second housings, whereby the rail mounting means is not loosed in a vibration condition so that any drop of the control device from the rail member may be prevented.

Other objectives and advantages of this invention will be more readily apparent from the following detailed description provided in conjunction with the following figures, of which:
Fig. 1 shows at (1) a plan view of a control device construction as a preferred embodiment of this invention, at (2) a left side view of the device construction, and at (3) a bottom view of the device construction;
Fig. 2 is a front view of the control device construction;
Fig. 3 is a rear view of the control device construction;
Fig. 4 is a perspective view of the control device construction in which a second housing is removed therefrom;
Fig. 5 is a perspective view of a first housing to be inserted by a terminal block in the control device construction;
Fig. 6 is a perspective disassembled view of the control device construction;
Fix. 7 is a cross-sectional view of the control device construction a part of which is omitted;
Fig. 8 is a plan view of the first housing of the control device construction;
Fig. 9 ie a view of the first housing viewed from an arrow mark A in Fig. 8;
Fig. 10 is a sectional view of the first housing taken along line B-B in Fig. 8;
Fig. 11 is a view of the first housing viewed from an arrow mark C in Fig. 8;
Fig. 12 is a plan view of the second housing of the control device construction;
Fig. 13 is a sectional view of the second housing taken along line D-D in Fig. 12;
Fig. 14 is a view of the second housing viewed from an arrow mark E in Fig. 12;
Fig. 15 shows at (1) a plan view of a first terminal block in the control device construction, at (2) a view of the block viewed from an arrow mark H at (1), at (3) a view of the block viewed from an arrow mark I at (1), and at (4) a view of the block viewed from an arrow mark J at (1)
Fig. 16 shows at (1) a plan view of second and third terminal blocks in the control device construction, at (2) a view of the blocks viewed from an arrow mark F at (1), and at (3) a view of the block viewed from an arrow mark G at (1).
Fig. 17 is a perspective view of a front module of the control device construction;
Fig. 18 is a perspective disassembled view of the front module of the control device construction;
Fig. 19 is a rear view of a switch base in the front module;
Fig. 20 is a view of the switch base viewed from an arrow mark K in Fig. 19;
Fig. 21 is a front view of the switch base in the front module;
Fig. 22 is a view of the switch base viewed from an arrow mark L in Fig. 19;
Fig. 23 shows at (1) an enlarged view of M section of Fig. 19, and at (2) a sectional view taken along N-N line at (1) of Fig. 23;
Fig. 24 shows at (1) a plan view of a rail hook member, at (2) a rear view of the member, at (3) a side view of the member, and at (4) a sectional view taken along line O-O at (1);
Fig. 25 is a front view of a front cover of the front module; ,
Fig. 26 is a view of the front cover viewed from an arrow mark P in Fig. 25;
Fig. 27 is a rear view of the front cover of the front module;
Fig. 28 is a view of the front cover viewed from an arrow mark Q in Fig. 25;
Fig. 29 shows at (1) a view of the front cover viewed from an arrow mark R in Fig. 26, and at (2) a view of the front cover viewed from an arrow mark S in Fig. 26;
Fig. 30 shows at (1) a view of the front cover viewed from an arrow mark T in Fig. 26, and at (2) a view of the front cover viewed from an arrow mark U in Fig. 26;
Fig. 31 shows a front view of a first or second switch body;
Fig. 32 is a sectional view of the switch body taken along line V-V in Fig. 31;
Fig. 33 shows at (1) a front view of a body of a first mode select switch, and at (2) a sectional view of the body taken along line W-W at (1) of Fig. 33;
Fig. 34 shows at (1) a front view of a body of a second mode select switch, and at (2) a sectional view of the body taken along line A-1-A-1 at (1) of Fig. 34;
Fig. 35 is a perspective view of an engagement means of the first and second housings;
Fig. 36 shows at (1) a perspective view of an engagement means of conventional first and second housings, and at (2) an illustration of an engagement of the conventional first and second housings;
Fig. 37 is a perspective view of the front module before mount on the first housing;
Fig. 38 is a sectional view of an engagement portion of the front module engaged with the first housing;
Fig. 39 is a perspective partial view of the first and second housings in which the second housing is opened from the first housing having a rail engagement portion;
Fig. 40 is a perspective partial view of the fist and second housings in which the first housing having a rail engagement portion is closed by the second housing;
Fig. 41 shows at (1) a plan view of a conventional control device construction, at (2) a left side view of the device construction, at (3) a front view of the device construction, and at (4) a rear view of the device construction;
Fig. 42 is a perspective disassembled view of the conventional control device construction;
Fig. 43 shows at (1) a perspective disassembled view of a switch of another conventional control device construction, and at (2) a partial sectional view of an engagement portion of a front cover engaged with a first housing in the switch of the conventional control device construction;
Fig. 44 is a perspective partial view of first and second housings in which the second housing is opened from a first housing having a rail engagement portion of still another conventional control device construction; and
Fig. 45 is a perspective partial view of the first and second housings in which the first housing having the rail engagement portion is closed by the second housing.

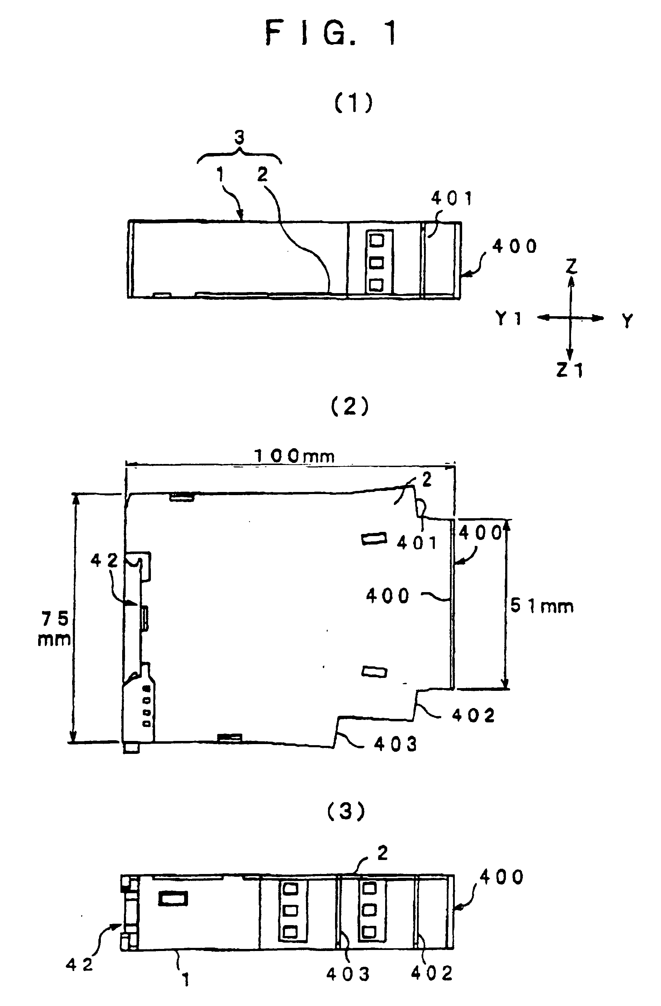

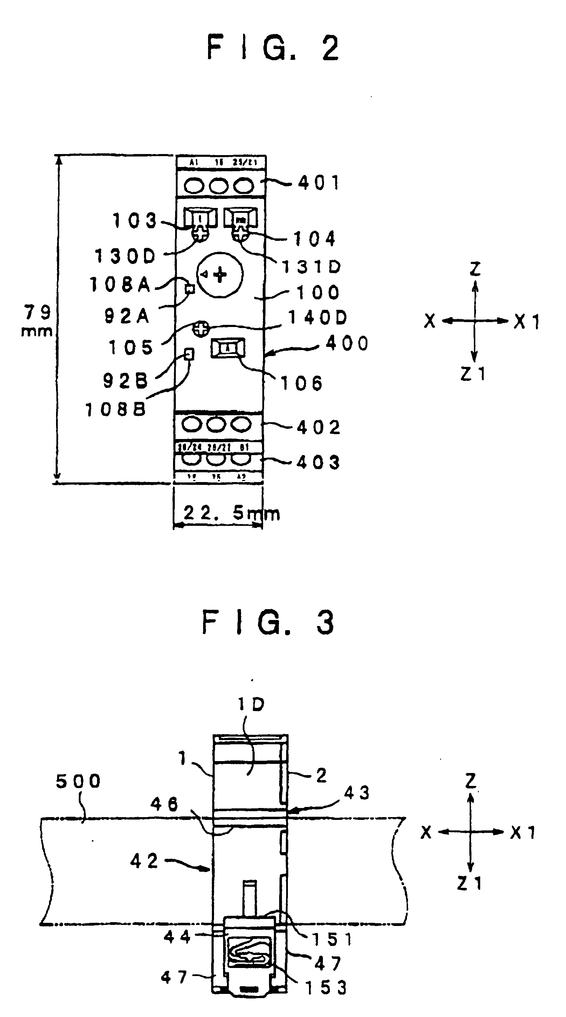

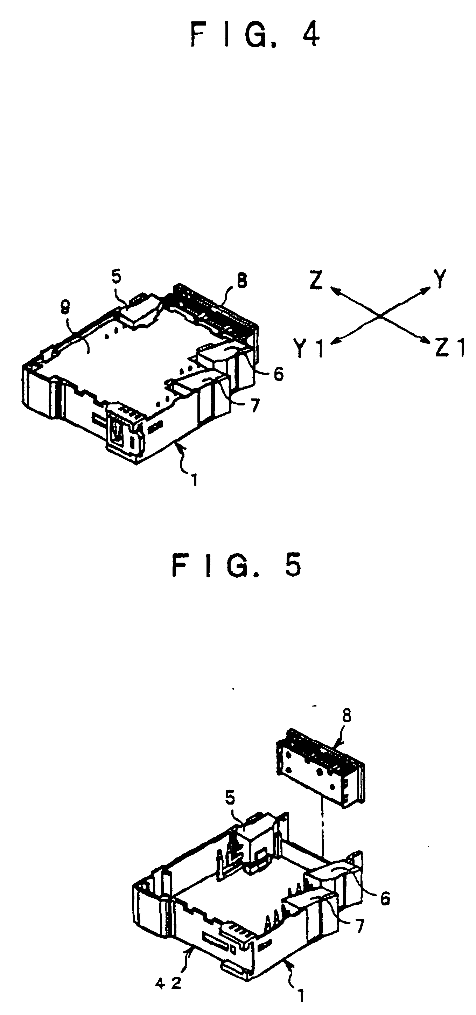

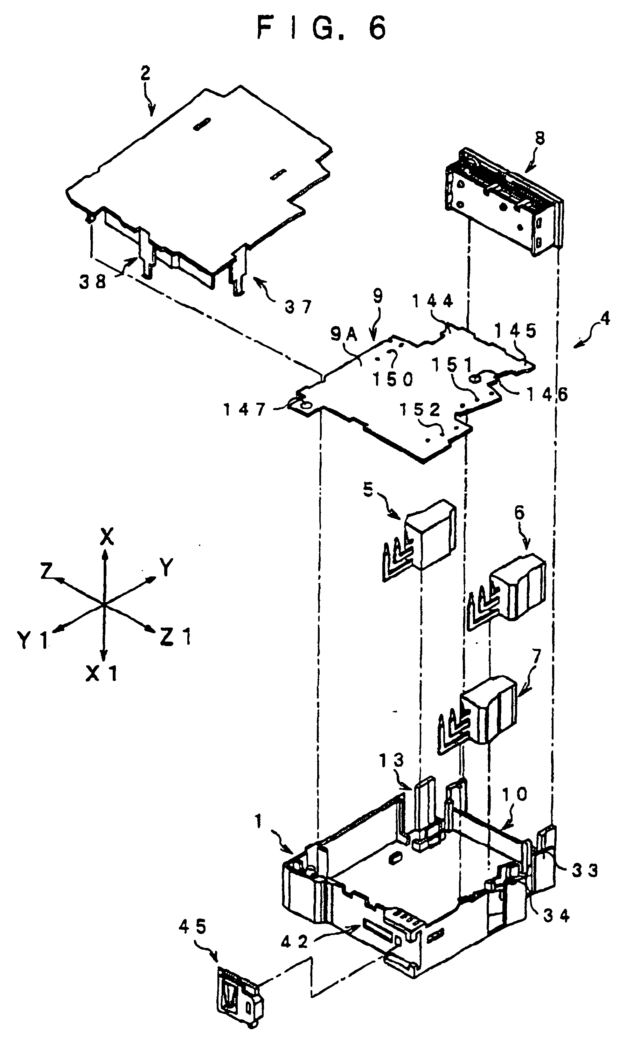

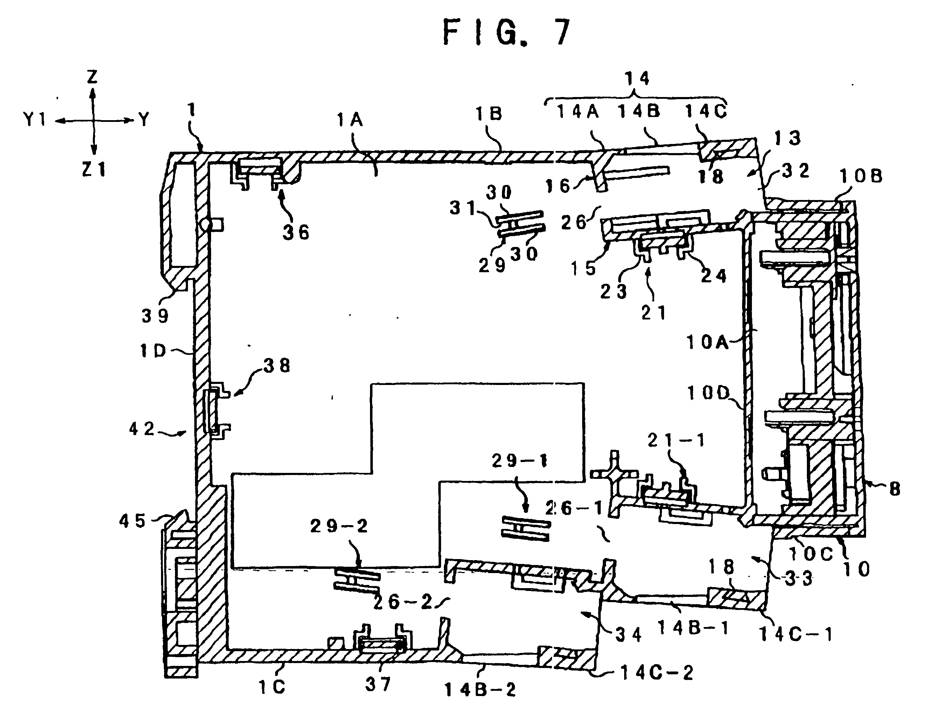

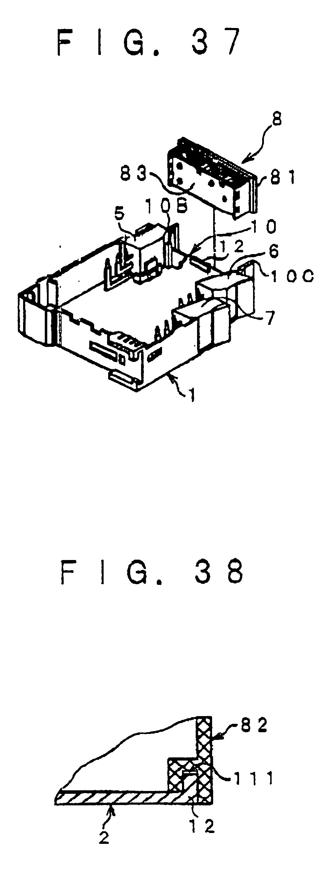

Referring, now, to Fig. 1, there is shown a control device construction as a preferred embodiment of this invention. Fig. 1 shows at (1) a plan view of the control device construction, at (2) a left side view of the device construction, and at (3) a bottom view of the device construction. Fig. 2 shows a front view of the control device construction. Fig. 3 shows a rear view of the control device construction. Fig. 4 shows a perspective view of the control device construction in which a second housing is removed therefrom. Fig. 5 and Fig. 37 show a perspective view of a first housing to be inserted by a terminal block in the control device construction. Fig. 6 shows a perspective disassembled view of the control device construction. Fig. 7 shows a cross-sectional view of the control device construction a part of which is omitted. In these drawings an arrow mark X-X1 shows a right and left direction, an arrow mark Y-Y1 shows a front and back direction, and an arrow mark Z-Z1 shows a top and bottom direction.

As shown in Fig. 6, the control device construction includes a first housing 1, a second housing 2, and an internal component 4 housed within a housing 3 consisting of the first and second housings 1 and 2. The internal component 4 includes first, second and third terminal blocks 5, 6 and 7, a front module 8, and a board unit 9 in which a plurality of electronic components are mounted on a printed circuit board 9A. In a front wall of the control device structure there are disposed an operation section 400, and terminal blocks 401, 402 and 403 arranged above and below the operation section 400. In a rear wall of the structure there is disposed a rail engagement section 42.

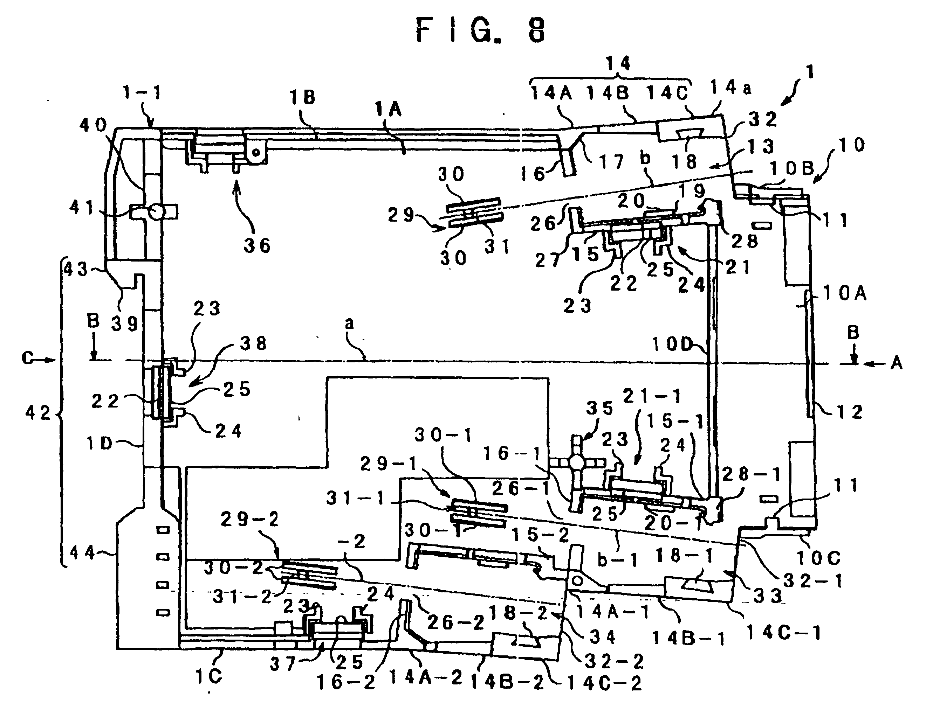

As shown in Figs. 8 to 11, the first housing 1 includes a housing body 1-1 of about a rectangular shape which is provided with a side wall 1A (right side), upper and lower walls 1B and 1C disposed at upper and lower edges of the side wall 1A, and a rear wall 1D disposed at a rear edge of the side wall 1A continuing for the upper and lower walls 1B and 1C. A left side of the housing body 1-1 is open, and a device unit mount section 10 is disposed in the front of the housing body 1-1.

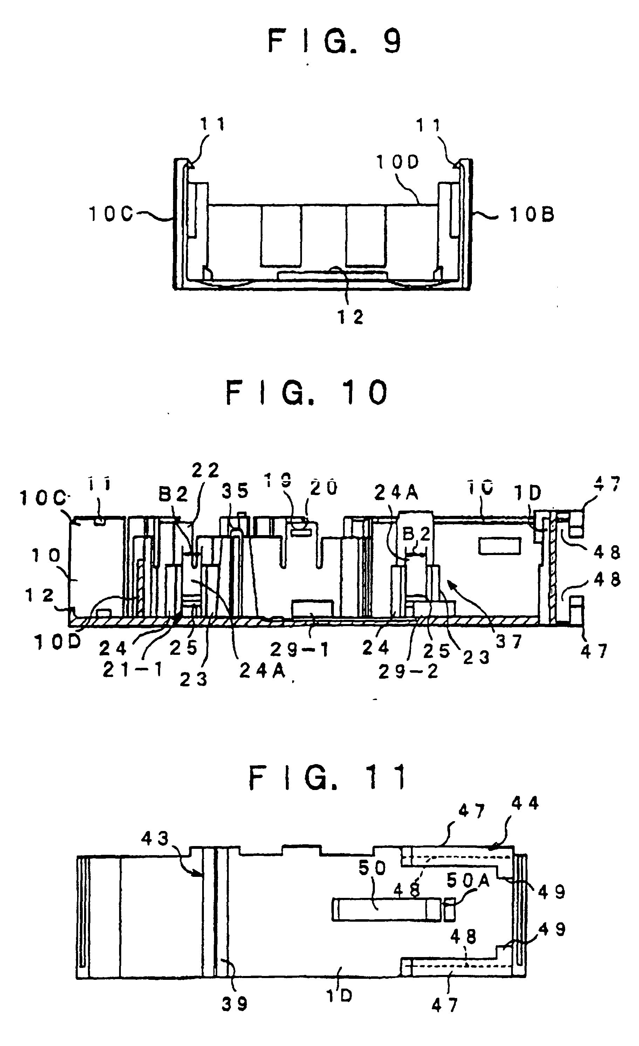

The device unit mount section 10 includes a side wall 10A extending from the side wall 1A of the housing body 1-1, upper and lower side pieces 10B and 10C formed at upper and lower edges of the side wall 10A, and a partition wall 10D disposed at a rear portion of the side wall 10A. The upper and lower side pieces 10B and 10C are separated from the partition wall 10D, and at top ends of their internal surfaces include engagement projections 11 to provide a hook means as shown in Fig. 9. At a front end side of an internal face of the side wall 10A, there is an engagement projection 12 having a elongated projection along in a vertical direction as shown in Fig. 8 and Fig. 38.

A first terminal block mount section 13 is formed on an inner wall of a front portion of the upper wall 1B of the first housing 1, and surrounded by an outer wall 14, an internal wall 15 and a rear wall 16 continuing for the walls 14 and 15 a side view of which is of a rectangular shape. An axis "b" of the first terminal block mount section 13 is inclined upward by a predetermined angle against an axis "a" of the first housing 1. The block mount section 13 at a front wall thereof is open to provide a terminal block expose window 32 located at an upper position of the device mount section 10.

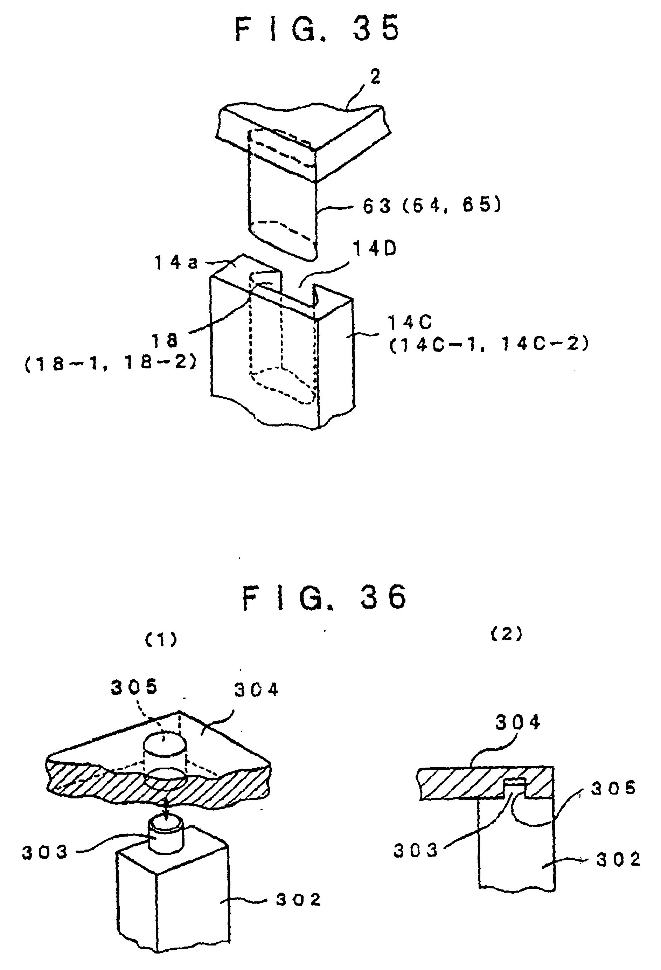

The outer wall 14 is composed of an outer hold wall 14A formed at a front end of the upper wall 1B, a lead wire derive portion 14B at a cut portion of the outer hold wall 14A, and a support pillar 14C standing in line with the lead wire derive portion 14B, wherein a slant wall 17 is formed at a corner of the outer hold wall 14A and the rear wall 16. The support pillar 14C on an inner face thereof is provided with an engagement groove 18 having an inner wide trapezoid section continuing to an end face 14a. As shown in Fig. 35, the engagement groove 18 disposed on the support pillar 14C continues to the end face 14a and has an open portion 14D opened to an inner wall of the pillar 14C.

The internal wall 15 at a middle thereof includes a hook piece 19 at an end of an inner face thereof having a hook projection 20 to compose a hook means. A first support pillar engagement portion 21 is disposed on an inner face of the internal wall 15, and includes a groove 22 disposed on an inner face of the internal wall 15 in a right and left direction and a pair of guide frames 23 and 24 formed on the inner face crossing the groove 22, in which an engagement projection 25 is formed on a back of the groove 22.

A terminal insertion portion 26 having a cut portion is disposed at a center of the rear wall 16. A pair of corner contact portions 27 and 28 are composed of an end face of an angular portion made by the rear wall 16 and the internal wall 15 and an end face of a front end of the internal wall 15. The terminal insertion portion 26 is located at the axis "b" of the first terminal block mount section 13, and a terminal hold portion 29 is disposed at an extension of the axis "b" to be composed of a hold groove 31 between a pair of piece portions 30 formed on an inner wall of the housing body 1-1.

On a front inner surface of the lower wall 1C of the firet housing 1 there are disposed a second terminal block mount section 33 and a third terminal block mount section 34. The second terminal block mount section 33 is axial symmetry with the first terminal block mount section 13 for a symmetric axis of the axis "a" of the first housing 1, and has a same construction as that of the first terminal block mount section 13. Accordingly, the same components as those of the first terminal block mount section 13 are assigned by the same reference numerals added by (-1), but its explanation is omitted.

On an extension of a rear wall 16-1 of the second terminal mount section 33 there is provided a position fix pin 35 continuing to the rear wall 16-1. A terminal insertion portion 26-1 is located at an axis "b-1" of the second terminal block mount section 33, and a terminal hold portion 29-1 is disposed at an extension of the axis "b-1" to be composed of a hold groove 31-1 between a pair of peace portions 30-1 formed on an inner wall of the housing body 1-1. The second block mount section 33 at a front wall thereof is open to provide a terminal block expose window 32-1 located at a lower position of the device mount section 10.

The third terminal block mount section 34 is placed behind and outwardly the second terminal block mount section 33, and has a same construction as that of the first terminal block mount section 13. Accordingly, the same components as those of the first terminal block mount section 13 are assigned by the same reference numerals added by (-2), but its explanation is omitted.

A terminal insertion portion 26-2 is located at an axis "b-2" of the third terminal block mount section 34, and a terminal hold portion 29-2 is disposed at an extension of the axis "b-2" to be composed of a hold groove 31-2 between a pair of piece portions 30-2 formed on an inner wall of the housing body 1-1. The third block mount section 34 at a front wall thereof is open to provide a terminal block expose window 32-2 located below the second terminal block mount section 33 providing a step.

Second, third, fourth and fifth support pillar engagement portions 21-1, 36, 37, and 38 are respectively disposed on an external face of an internal wall 15-1 of the second terminal block mount section 33, a rear of an inner face of the upper wall 1B of the first housing 1, an inner face of the lower wall 1C, and a center of an inner face of the rear wall 1D. Each of the support pillar engagement portions 21-1, 36, 37 and 38 has the same construction as that of the support pillar engagement portion 21, and includes a groove 22 disposed on an inner face of the wall in a right and left direction and a pair of guide frames 23 and 24 formed on the inner face crossing the groove 22, in which an engagement projection 25 is formed on a back of the groove 22.

An upper portion of the rear wall 1D of the first housing 1 is cut out, and a position fix pin 41 is formed on the cutout portion 40.

A rail engagement portion 42 is disposed on an external side of the rear wall 1D of the first housing 1, and composed of an upper rail hook portion 43 formed on an external face of the rear wall 1D as a single unit and a lower rail hook portion 44 which is removably mounted by a rail hook member 45. The upper rail hook portion 43 includes an engagement hook 46 (39) extending downwardly which is formed on the external side of the rear wall 1D as a single unit. The lower rail hook portion 44 includes a pair of hook engagement groove formation portions 47 formed on a lower of the external side of the rear wall 1D, on opposing sides of which hook engagement grooves 48 are disposed along a vertical direction. At lower portions of the hook engagement groove formation portions 47, there are provided engagement projections 49. A groove 50 and an engagement projection 50A are formed on a lower center of the external side of the rear wall 1D along a vertical direction.

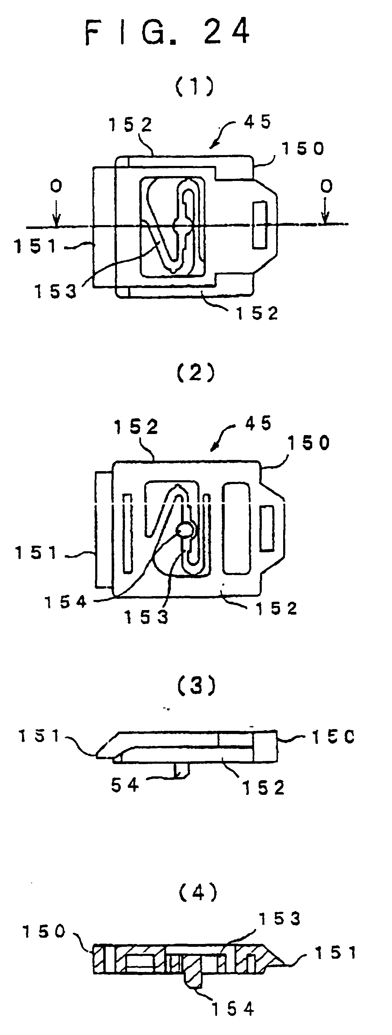

As shown in Fig. 24 (1) to (4), the rail hook member 45 is provided with a hook body 150 having a plan view of a rectangular shape. The hook body 150 at a top end thereof includes an engagement hook 151, on both sides thereof engagement guide portions 152, and a S-shaped spring 153 on a rear side thereof having a engagement projection 154.

The engagement projection 154 of the rail hook member 45 is inserted into the groove 50 and the engagement guide portions 52 are inserted into the hook engagement grooves 48 to be depressed downwardly so that the engagement guide portions may be engaged with the hook engagement grooves and the engagement projection 154 may be engaged with the engagement projection 50A. The rail hook member 45 is mounted on an external face of the rear wall 1D, the engagement hook 151 of the rail hook member 45 is located opposite to the engagement hook 46 of the upper rail hook portion 43, and the rail hook member 45 is vertically movable within an extent of bent by the spring 153.

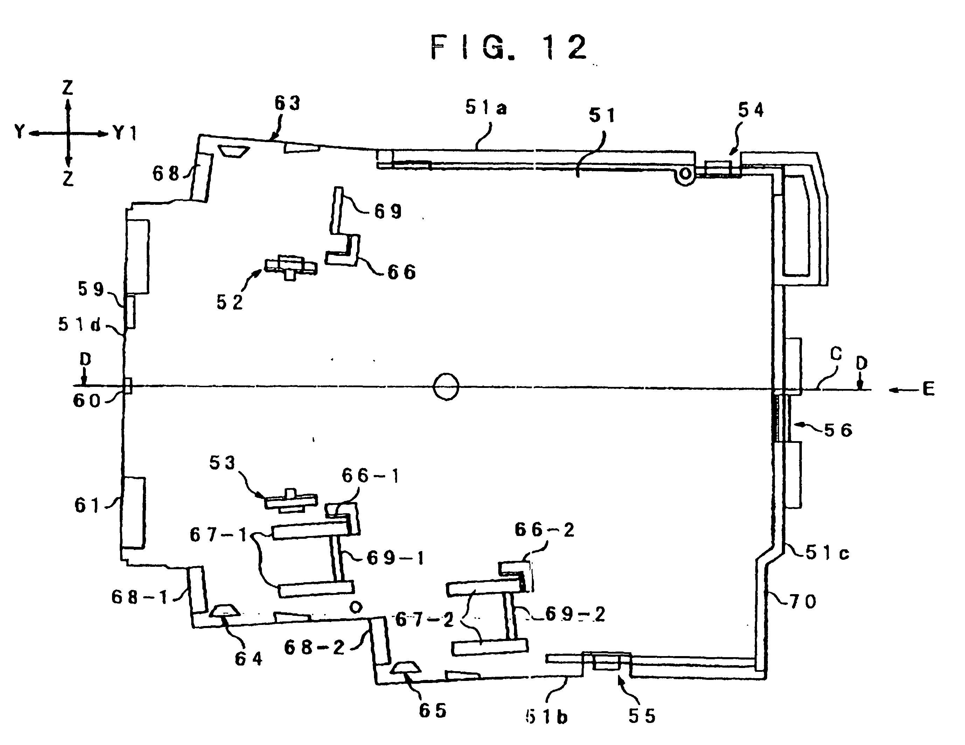

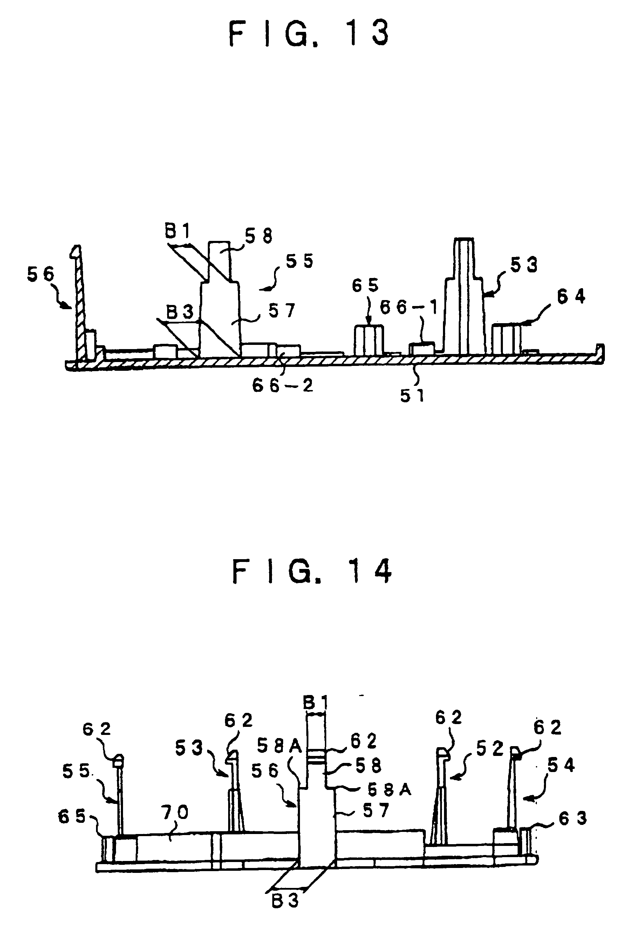

As shown in Figs. 12 to 14, the second housing 2 includes a plate shaped housing body 51 having a same shape as that of the first housing 1. On an inner wall of the housing body 51, first and second engagement pillars 52 and 53 are disposed at symmetrical positions across an axis "c" of the housing body 51, and an engagement wall 70 is disposed at a rear half portion of the upper and lower edges Sla and 51b and the rear edge 51c. Third and fourth engagement pillars 54 and 55 are disposed to project from upper and lower sides of the engagement wall 70, and a fifth engagement pillar 56 is disposed to project from a rear side of the wall 70.

Each of the first to fifth engagement pillars 52 to 56 includes a narrow insertion portion 58 at a top of its pillar body 57, and a top side of the insertion portion 58 includes an engagement hook 62, in which a step 58A is formed between the pillar body 57 of the insertion portion 58 and the portion 58. The width B1 of the insertion portion 58 is smaller than the scale B2 of a gap 24A between a pair of guide frame portions 23 and 24 of the first to fifth support pillar engagement portions 21, 21-1, 36, 37 and 38, and the width B3 of the pillar body 57 is larger than the scale B2 of the gap 24A.

Three rib-shaped engagement projections 59, 60 and 61 are formed on a front edge 51d of the first housing 1, a first engagement portion 63 is disposed at a front side of the upper edge 51a of the first housing 1, and second and third engagement portions 64 and 65 are disposed at the lower edge 51b. Each of the first to third engagement portions 63 to 65 has a section of a trapezoid. A corner projection 66 and contact portions 68 and 69 contacting an end face of the first terminal block 5 are disposed on an inner face of the housing body 51 opposite to the first terminal mount portion 13 of the first housing 1.

At a position of an inner face of the housing body 51 opposite to the second terminal block mount portion 33 of the first housing 1, there are disposed a corner projection 66-1, an insertion groove portion 67-1 inserted by a projection 79 at an end face of the second terminal block 6, and contact portions 68-1 and 69-1 contacting the end face of the second terminal block 6. At a position of an inner face of the housing body 51 opposite to the third terminal block mount portion 34 of the first houssing 1, there are disposed a corner projection 66-2, an insertion groove portion 67-2 inserted by a projection 79 at an end face 71c of the second terminal block 6, and contact portions 68-2 and 69-2 contacting the end face 71c of the second terminal block 6.

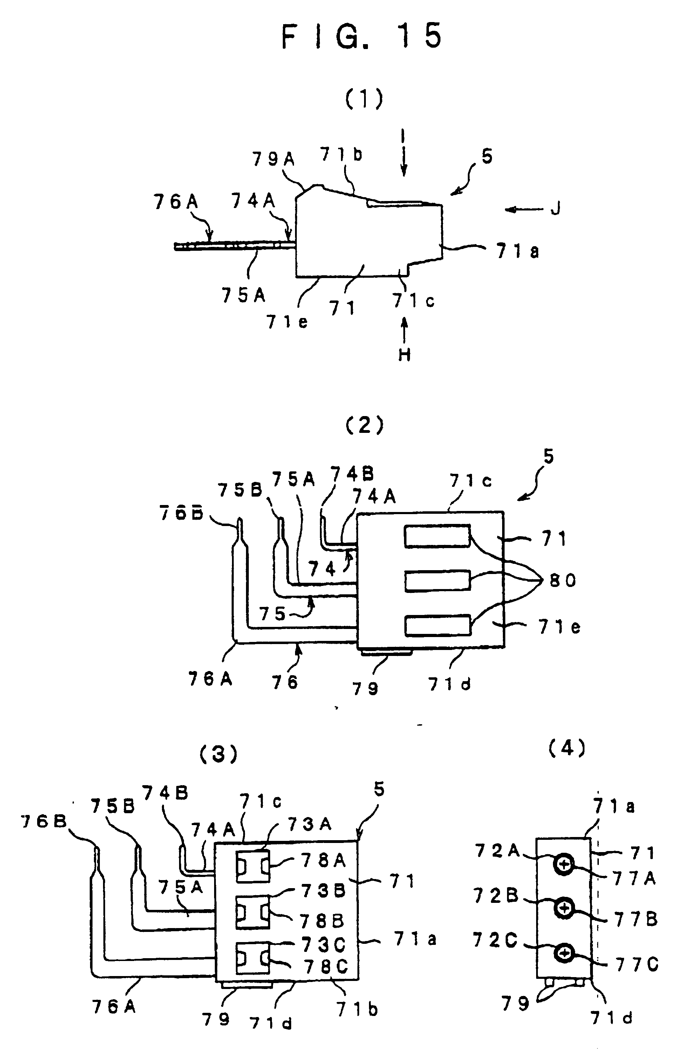

As shown in Fig. 15 (1) to (4), the first terminal block 5 is provided with a terminal block body 71 of an insulated block in which first, second and third terminals 74, 75 and 76 are arranged lengthwise. Terminal base portions 74A to 76A of the first to third terminals 74 to 76 are designed to project outwardly of a rear end of the terminal block body 71, and at middle portions thereof bend at right angles. Bent ends 74B, 75B and 76B of the terminals are generally positioned within a plane including one terminal face 71c of the terminal block body 71.

Three screw operation portions 72A, 72B and 72C are disposed on a front end face 71a of the terminal block body 71, and three lead wire connectors 73A, 73B and 73C are disposed on an external face 71b of the terminal block body 71. The screw operation portions 72A, 72B and 72C are provided with operation screws 77A, 77B and 77C adapted to be rotated to move lead wire catch members 78A, 78B and 78C to hold the leads within the lead wire connection portions 73A, 73B and 73C.

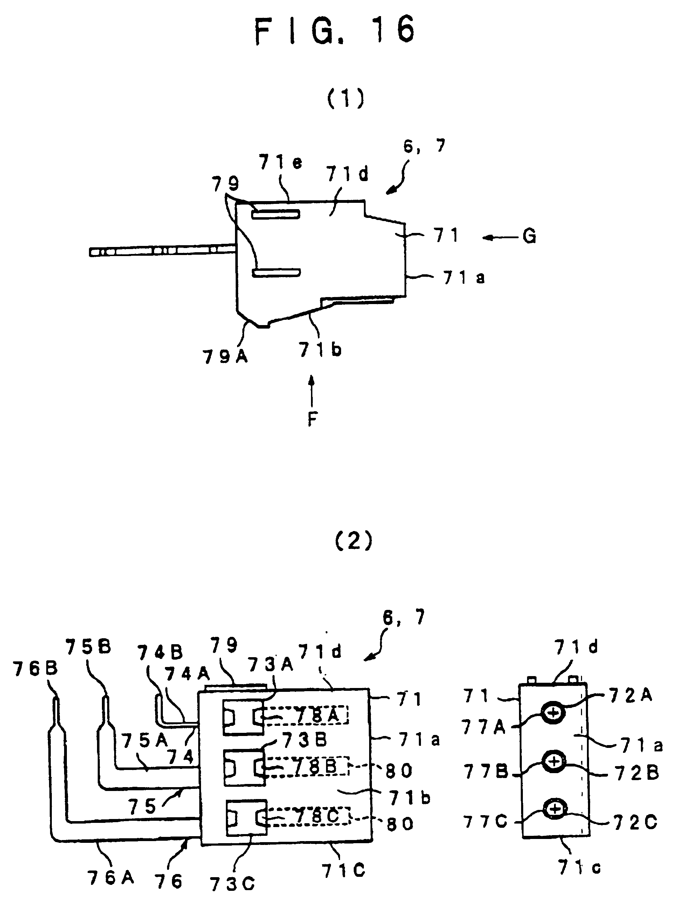

As shown in Fig. 16 (1) to (3), the second and third terminal blocks 6 and 7 have same constructions as that of the first terminal block 5, but the direction of the terminal block body 71 is axial symmetrical to the first terminal block 5, in which one end face 71c is positioned at the first housing and bent ends 74B, 75B and 76B of terminal bases 74A, 75A and 76A are generally positioned in a plane including other end face 71d of the terminal block body 71.

Accordingly, the one end face 71c in the first terminal block 5 is located at the open side of the first housing 1, and the other end face 71d in the second and third terminal blocks is located at the open side of the first housing 1. The other end face 71d of the second and third terminal blocks 6 and 7 is provided with the projection 79. The rea edge of the external surface 71b of the terminal block body 71 of the first to third terminal blocks 5 to 7 composes the slant face 79, and the hook groove portion 80 is disposed on an inner surface 71e of the terminal block body 71.

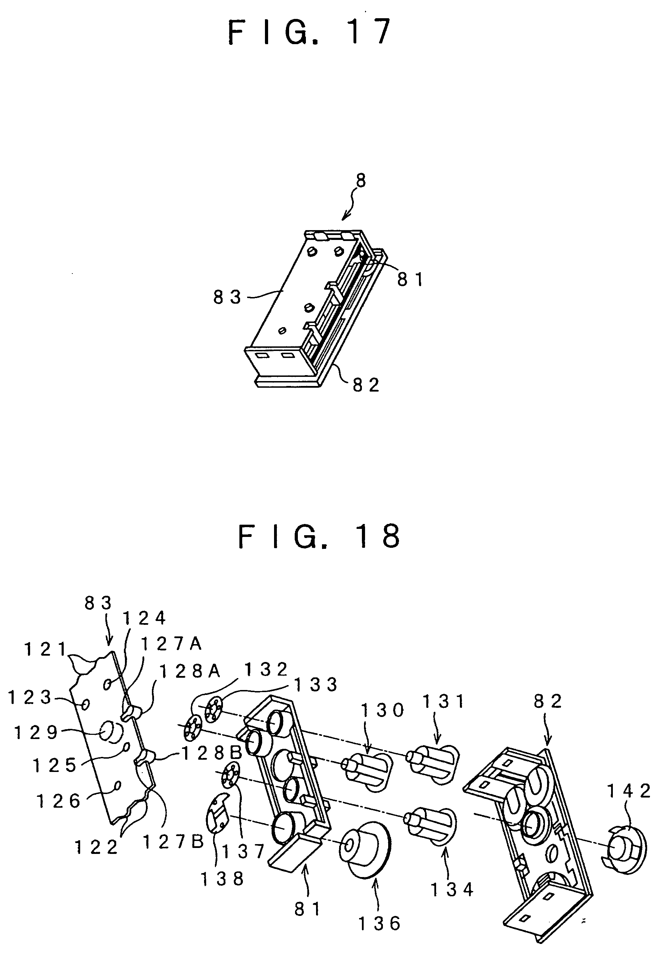

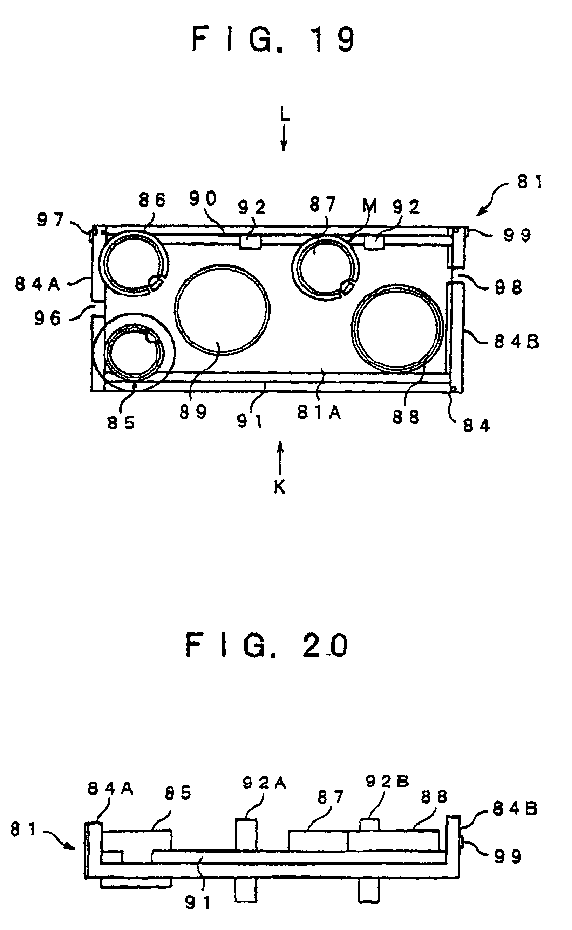

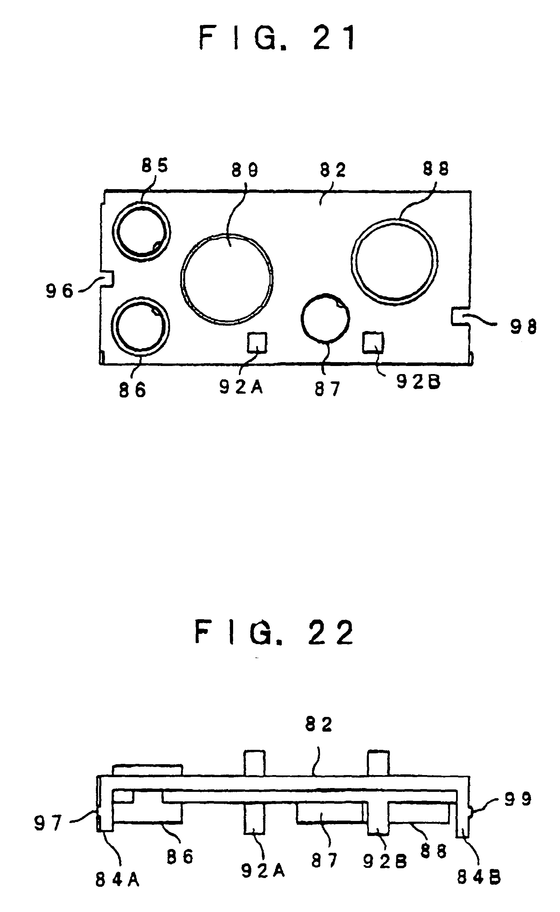

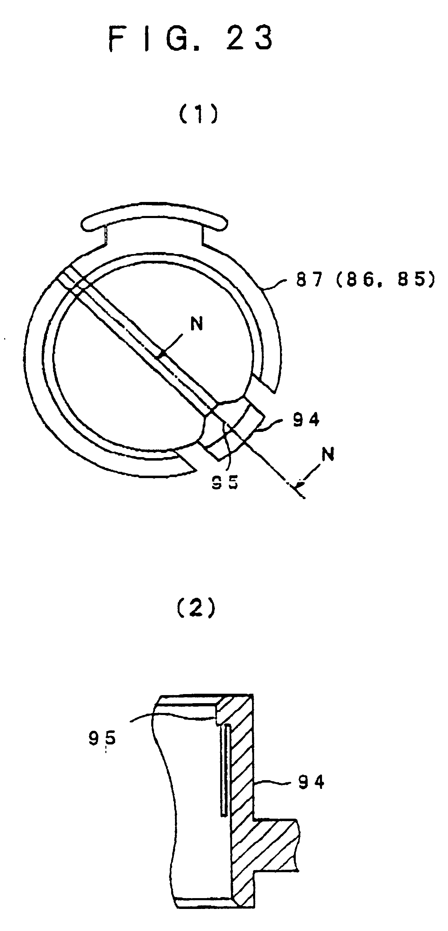

As shown in Figs. 17 and 18, the front module 8 includes a switch base member 81, a front cover 82, and a printed circuit board 83 mounted by electronic components. As shown in Figs. 19 to 23, the switch base member 81 is provided with a member body 84 formed by backwardly bending mount pieces 84A and 84B above and below a wall 81A. Components described later including the switch base member 81 are made of transparent synthetic resin, and compose a single unit. On the wall 81A of the member body 84, there are disposed first and second switch hold cylinders 85 and 86, first and second mode select switch hold cylinders 87 and 88, and a hole 89 for a dial. A part of the first and second switch hold cylinders 85 and 86 and the first mode select switch hold cylinder 87 is provided with one hold piece 94 having at a top of an internal surface thereof a projection 95 as shown in Fig. 23 (1) and (2).

Rib projections 90 and 91 are disposed on both edge sides of an inner face of the wall 81A. On the rib projection 90 there are disposed a pair of optical guides 92A and 92B in a forward and backward direction. A slit 96 is disposed in a center of on one mount pierce 84A along a forward and backward direction, and a hook projection portion 97 is disposed at one side of the one mount piece 84A. A slit 98 is disposed in a position shifting from a center of on other mount pierce 84B to its side along a forward and backward direction, and a hook projection portion 99 is disposed near the side.

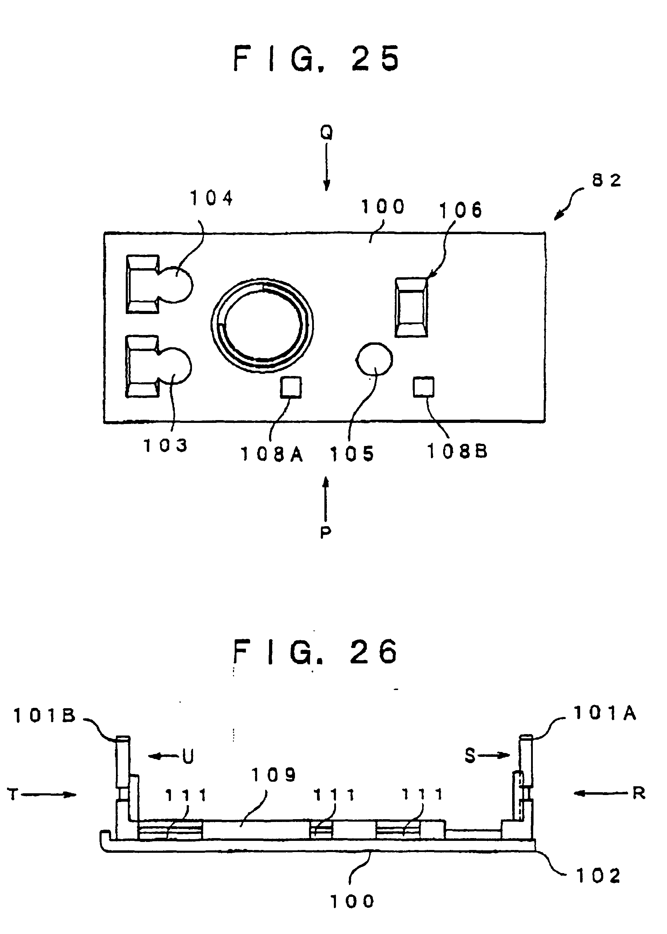

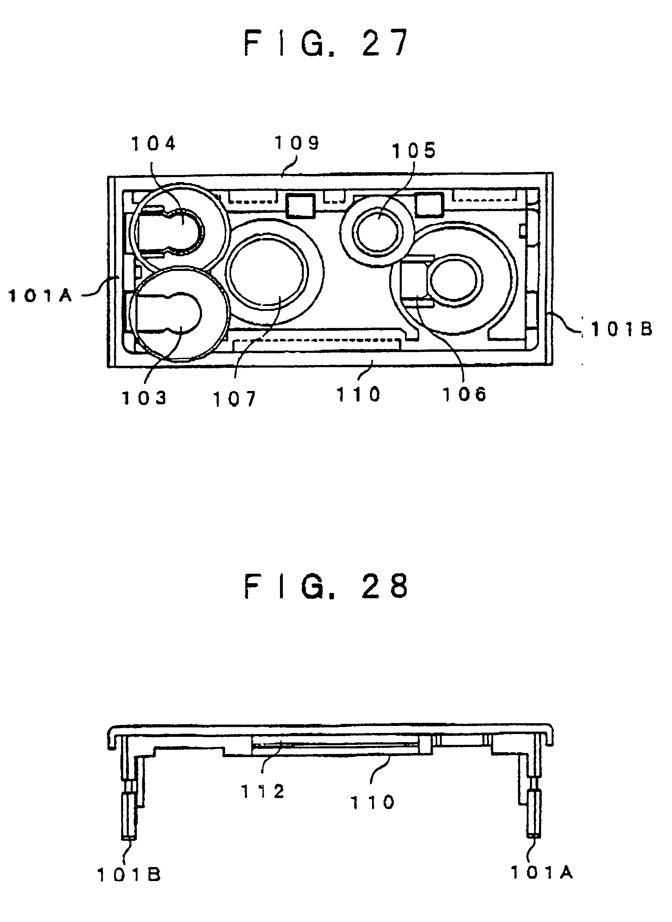

As shown in Figs. 25 to 30, the front cover member 82 is provided with a member body 102 molded by first and second mount pieces 101A and 101B bent outwardly on upper and lower sides of the wall 100, and the wall 100 is provided with first and second switch windows 103 and 104, a first mode select switch manipulation window 105, a second mode select switch manipulation window 106, a dial opening 107, and a pair of display windows 108A and 108B.

On both side edges of the wall 100 in a right and left direction, there are rib projections 109 and 110. A plurality of engagement recess portions 111 are formed outwardly of the left rib projection 109, and a recess portion 112 is formed outwardly of the right rib projection 110.

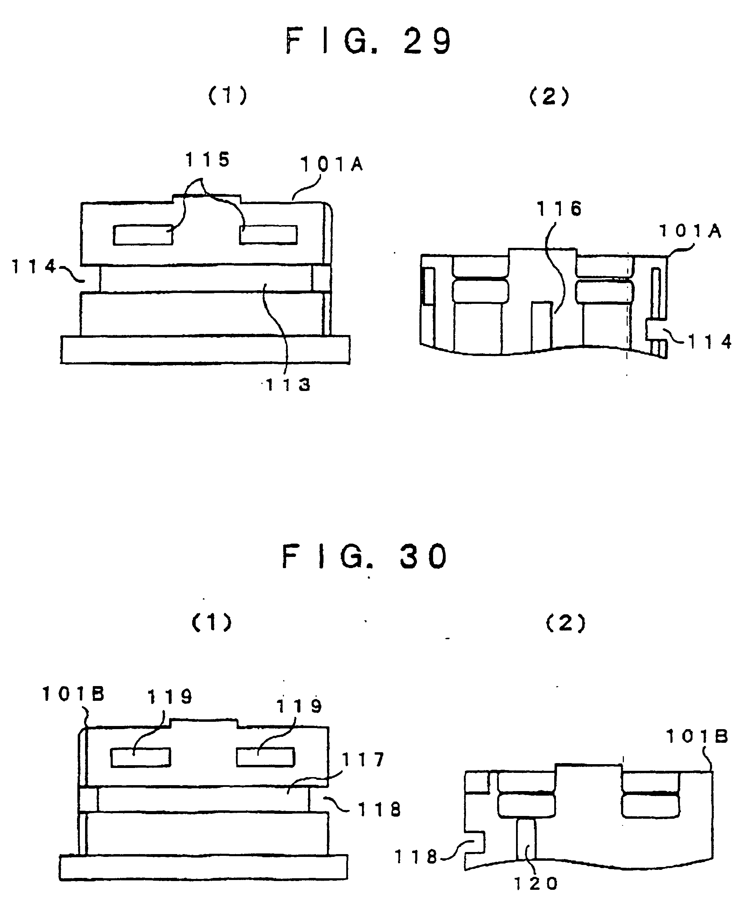

As shown in Fig. 29 (1) and (2), there are disposed on an external surface of the first mount piece 101A a groove portion 113 along in a right and left direction, a hook cutout portion 114 for hooking located at a left end of the groove portion 113 and a pair of hook openings 115 located at a front side of the portion 113. On an inner face of the first mount piece 101A there is disposed a rib projection 116 located at a center of the piece 101A. As shown in Fig. 30 (1) and (2), there are disposed on an external surface of the second mount piece 101B a groove portion 117 along in a right and left direction, a hook cutout portion 118 for hooking located at a left end of the groove portion 117 and a pair of hook openings 119 located at a front side of the portion 117. On an inner face of the second mount piece 101B there is disposed a rib projection 120 located at a center of the piece 101B.

As shown in Fig. 18, upper and lower ends of the printed circuit board 83 mounted by electronic components are provided with pairs of hook portions 121 and 122. On a mount wall of the board 83 there are disposed first and second switch openings 123 and 124, first and second mode select switch openings 125 and 126, and an electrically conductive pattern (not shown in drawings) with respect to the openings 123 to 126. A pair of cutout portions 127A and 127B formed at a left edge of the mount surface of the printed circuit board 83 are respectively mounted by light emitting diodes 128A and 128B. A setting variable resistor 123 is mounted on the mount surface of the printed circuit board 83.

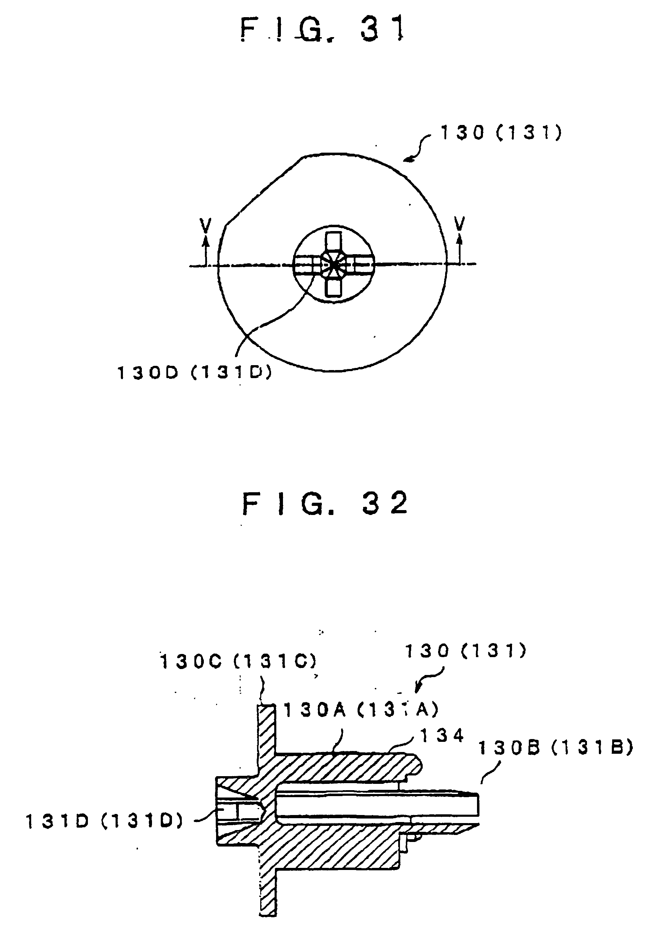

As shown in Figs. 31 and 32, shaft portions 130A and 131A of the first and second switch bodies 130 and 131 are rotatably penetrated through the first and second switch hold cylinders 85 and 86, and small diameter portions 130B and 131B of penetrate-through-ends of the shaft portions 130A and 131A are mounted by slide elements 132 and 133. A plurality of grooves 134 along an axial direction of the shaft portions 130A and 131A are disposed on a periphery of the shaft portions 130A and 131A in a peripheral direction by a predetermined spacing. A projection 95 of a top end of an internal face of the one hold piece 94 is removably inserted into one of the grooves 134. Flanges 130C and 131C are formed at ends of the shaft portions 130A and 131A of the first and second switch bodies 130 and 131, and at centers thereof provided with cross grooves 130D and 131D to be engaged by a rotary tool.

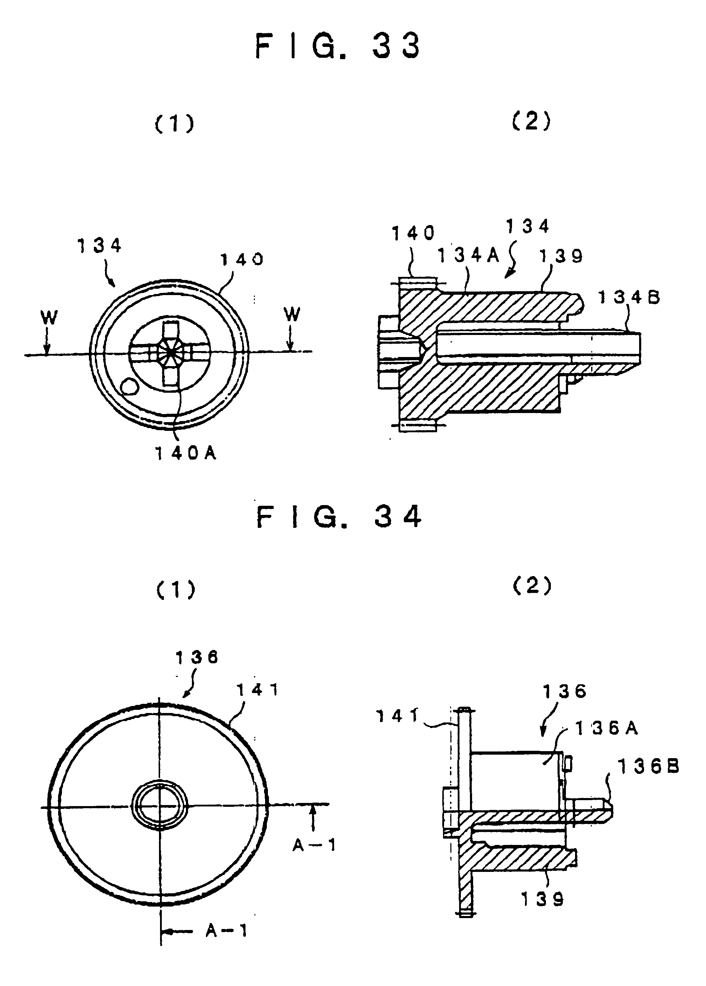

As shown in Figs. 33 and 34, shaft portions 134A and 136A of the first and second mode select switch bodies 134 and 136 are rotatably penetrated through the first and second mode switch hold cylinders 87 and 88, and small diameter portions 134B and 136B of penetrate-through-ends of the shaft portions 134A and 136A are mounted by slide elements 137 and 138. A plurality of grooves 139 along an axial direction of the shaft portions 134A and 136A are disposed on a periphery of the shaft portions 134A and 136A in a peripheral direction by a predetermined spacing. A projection 95 of a top end of an internal face of the one hold piece 94 is removably inserted int one of the grooves 139. Gears 140 and 141 are disposed on ends of the shaft portions 134A and 136A of the first and second mode select switch bodies 134 and 136, and engaged each other. The gear 140 at a center thereof is provided with a cross groove 140A.

The front cover member 82 is mounted on the switch base member 81 mounted by the first and second switch bodies 130 and 131 and the first and second mode select switch bodies 134 and 136. The rib projections 116 and 120 of the one and other mount pieces 101A and 101B of the front cover member 82 are inserted into slits 96 and 98 of the one and other mount pieces 83A and 83B of the switch base member 81 to move the front cover member 82 toward the switch base member 81 so that the hook projections 97 and 99 are hooked by the hook cutout portions 114 and 118.

In this construction, the flanges 130C and 131C of the shaft ends of the first and second mode select switch bodies 134 and 136 are opposite to the first and second switch windows 103 and 104, the cross grooves 130D and 131D are located within the first and second switch windows 103 and 104, the gear 140 of the shaft end of the first mode select switch body 134 is opposite to the first mode select switch manipulation window 105, the cross groove 140A is located within the first mode select switch manipulation window 105, the gear 141 of the shaft end of the second mode select switch body 136 is opposite to the second mode select switch window 106, and the dial opening 89 is opposite to the dial opening 107. The pair of the optical guide portions 92A and 92B are inserted into the pair of display windows 108A and 108B.

The hooks 121 and 122 at the upper and lower ends of the printed circuit board 83 mounted by the electronic components are hooked by the hook openings 115 and 119 of the one and other mount pieces 101A and 101B of the front cover member 82, so that the printed circuit board 83 is mounted by the front cover member 82 and the slide elements 132, 133, 137 and 138 are slidably contacted with the electrically conductive pattern. The electronic components 129 for setting variable resistor is inserted into the dial openings 89 and 107, and installed by a dial 142, the light emitting diodes 128A and 128B come into contact with the pair of optical guide portions 92A and 92B.

The board unit 9 having the board 9A mounted by many electronic components has a same shape as that of the open side of the first housing 1, and is provided with the contact portions 144 and 145 contacted by the corner contact portions 27 and 28 of the first housing 1 and the position fix openings 146 and 147 to be inserted by the position fix pins 35 and 41 of the first housing 1.

An assemble process of the control device construction of this embodiment will be described hereinafter.

First, the first terminal block 5 is mounted on the first terminal block mount section 13 of the first housing 1, the second terminal block 6 is mounted on the second terminal block mount portion 33, and the third terminal block 7 is mounted on the third terminal block mount portion 34. As the first terminal block 5 is inserted into the first terminal block mount section 13, the hook projection portion 20 of the hook piece portion 19 of the internal wall 15 of the terminal block mount section 13 is hooked by the hook groove portion 80 on the inner face of the first terminal block 5, and the terminal leg portion 76A of the first terminal block 5 is inserted to the hold groove 31 of the terminal leg hold portion 29 to be held thereby. The slant face 79 at the rear edge of the external surface of the first terminal block 5 comes into contact with the slant face portion 17, the front end face 71a having the three screw manipulation portions 72A, 72B and 72C of the first terminal block 5 is located in the terminal block expose window 32, and the lead wire connection portions 73A, 73B and 73C of the external surface of the first terminal block 5 are exposed from the lead wire derive portion 14B.

Mounting the second terminal block 6 to the second terminal block mount section 33 and of the third terminal block 7 to the third terminal block mount section 34 is executed in the same way as mounting the first terminal block 5 to the first terminal block mount section 13.

Next, the front module 8 is mounted on the device unit mount section 10. The groove portions 113 and 117 on the external surface of the one and other mount pieces 101A and 101B of the front cover 82 of the front module 8 are secured into the engagement projection portion 11, so that the engagement projection portion 11 is hooked by the hook cutout portions 114 and 118 and the engagement projection 12 is inserted int the engagement recess portion 112 of the rib projection 110 of the front cover 82. Then, the front side of the front module 8 is located forward to generally compose the manipulation portion 400.

Next, the board unit 9 is engaged with the open side of the first housing 1 to make the contact portions 144 and 145 contact with the corner contact portions 27 and 28 and to insert the position fix pins 35 and 41 of the first housing 1 to the position fix opening portions 146 and 147. Then, the bent ends 74B to 76B of the first to third terminal leg portions 74A to 76A of the first to third terminal blocks 5 to 7 are inserted into the through holes 150 to 152 of the printed circuit board 9 to be soldered, and the printed circuit board 83 of the front module 8 is soldered to be bridged to the board 9A of the board unit 9 for connection.

Then, the second housing 2 is mounted on the first housing 1. That is, the first to fifth engagement pillar bodies 52 to 56 of the second housing 2 are inserted into the first to fifth pillar engagement portions 21, 21-1, 36, 37 and 38 of the first housing 1 whereby the narrow width insertion portions 58 of the top portions of the pillar bodies 57 of the first to fifth engagement pillar bodies 52 to 56 are fitted to the groove portions 22 of the internal wall 15 of the first to fifth pillar engagement portions 21, 21-1, 36, 37 and 38. As the second housing 2 is inserted in this state, the engagement hook 62 of the top end of the insertion portion 58 passes over the engagement projection 25 for engagement with the projection 25. Though the insertion portion 58 goes out of the gap 24A between the pair of guide frame portions 23 and 24 when the engagement hook 62 passes over the engagement projection, the width wide pillar bodies 57 of the first to fifth pillar engagement portions 21, 21-1, 36, 37 and 38 are inserted into the guide frame portions 23 and 24 when the engagement hook 62 is engaged with the engagement projection portion 25.

Then, the first, second and third engagement portions 63, 64 and 65 are inserted into the engagement groove portions 18, 18C-1, and 18C-2 to be engaged therewith, the three engagement projection portions 59 to 61 of the front side edge 51C of the housing body 51 are engaged with the engagement recess portion 111 of the front cover 82 of the front module 8, the corner projection portions 66, 66-1 and 66-2 on the internal wall of the second housing 2 are coupled with the corners of the rear side inner ends of the first, second and third terminal blocks 5,6 and 7, the contact portions 68 and 69 come into contact with the end face 71d of the first terminal block 5, the contact portions 68-1 and 69-1 come into contact with the end face 71c of the second terminal block 6, the contact portions 68-2 and 69-2 come into contact with the end face 71c of the second terminal block 7, so that the first, second and third terminals 5, 6 and 7 are laterally pushed.

As shown in Fig. 35, when the first, second and third engagement portions 63, 64 and 65 are inserted into the engagement groove portions 18, 18-1, and 18-2 of the support pillar portions 14C, 14C-1 and 14C-2 to be engaged therewith, the engagement groove portion 18 passes to the end faces of the support pillar portions 14C, 14C-1 and 14C-2 and includes an open portion 140 opened to the internal faces of the support pillar portions 14C, 14C-1 and 14C-2, so that the engagement groove portions 18, 18-1 and 18-2 are expanded to the both sides across the open portion 14D and the first to third engagement portions 63 to 65 may be easily inserted into the engagement groove portions 18, 18-1, and 18-2 of the support pillar portions 14C, 14C-1 and 14C-2. Accordingly, the second housing 2 may be firmly engaged with the first housing 1 even if there is slightly twist or positional shift in the first and second housings 1 and 2.

In a convectional coupling for the first and second housings as shown in Fig. 36 (1) and (2), an engagement projection portion 303 is disposed on an end face of the support pillar portion 302 of the first housing (not shown in drawings) and an engagement recess portion 305 is disposed on the second housing 304 for engaging the engagement projection portion 303 with the engagement recess portion 305 for the coupling of the first and second housings. When there are some torsion or positional shift in a mold of the first housing and the second housing 304, the engagement projection portion 303 is shifted from the engagement recess portion 305, so that there is a disadvantage such that the second housing 304 cannot be firmly engaged with the first housing.

As shown in Fig. 3 thus constructed control device construction is mounted on the rail member 500 by catching the rail member 500 with the upper rail hook portion 43 of the rail engagement portion 42 disposed on the rear wall portion 1D of the first housing 1 and the lower rail hook member 44.

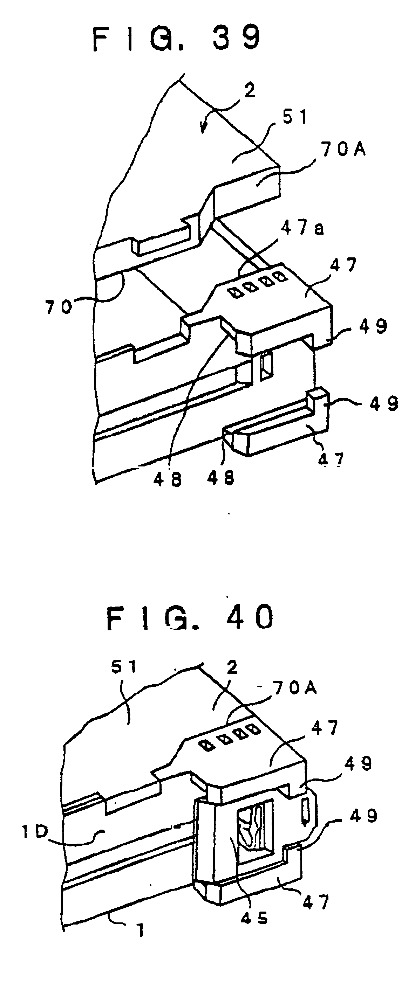

The pair of hook hold groove formation portions 47 of the lower rail hook member 44 shown in Fig. 39 (the second housing 2 is opened from the first housing 1 ) and Fig. 40 (the second housing 2 is closed to the first housing 1) are disposed on the external surface of the rear wall 1D of the first housing 1, not across the first and second housings 1 and 2, so that the rail engagement portion 42 is not loosed in a vibration condition and the control device is avoided from drop from the rail member 500 by disengagement. If desired, the rail engagement portion 42 disposed on the first housing 1 may be disposed on a rear portion of the second housing 2.

According to this embodiment, any soldering positioning jig required in a conventional board assembling is not necessary, the board unit 9 may be assembled by installing into the first housing 1, resulting into the reduction of the assembly process, though conventional internal assembly on a board is a different process from installation of the assembly into the housings 1 and 2. The front module 8 may be assembled vertically against the first housing 1 to install the front module 8 from the open side of the first housing 1 to the part install side, so that the thickness of the housing does not decrease the operation display area in assembling though the conventional operation display area is decreased.

Though conventionally a switch section is assembled in assembling the board and a dial knob is installed from a front wall after body assembling, the operation board and the respective components are assembled beforehand as one module, whereby the number of the parts and the assembly steps is decreased. The module configuration of the front module makes the intermediate assembly control easy.

The front module 8 and the first, second and third terminal blocks 5, 6 and 7 may be separately installed into the first housing 1, whereby such a conventional tradeoff relation between the occupation area by the front portion of the terminal block and the occupation area by the operation section viewed from the front is loosed. That is, this control device construction may have additional one array of a terminal block, which is reduced to the scale 51 mm against the scale 54 mm of a conventional operation section.

The number of terminal blocks may be increased without decreasing the scale of the operation section by tilting the first, second and third terminal block mount sections 13, 33 and 34 so that axes "b" passing centers of the terminal block mount sections 13, 33 and 34 may be tilted outwardly against the axis "a" passing the device unit mount portion 10 of the housing body 1-1 of the first housing 1 and the terminal block expose windows 32, 32-1 and 32-2 may be tilted outwardly.

In this embodiment, the switch construction is made by units, the front module 8 as the switch unit is mounted on the module mount section 10 disposed on the first housing 1, the front module 8 is engaged with the module mount portion 10 by the engagement means (the engagement by the engagement projection portion 12 and the engagement recess 111 as shown in Fig. 38, and the engagement by the engagement projection portions 59, 60 and 61 and the engagement recess portion 112), whereby the slide elements 132, 133, 137 and 138 as press components are avoided from bent by reaction force made by being pressed against the respective conductive patterns. Therefore one press component may be made for each switch, whereby the cost of the components is reduced and the number of assembly steps is decreased.

## Claims

1. A control device comprising:
a first housing (1) having a part install side at one side thereof and. an open side at the other side thereof so that parts installation may be made from said part install side to said open side,
a front module (8) which is installed from said open side of said first housing (1) to said part install side,
a board unit (9) which is mounted on said open side to be connected with said front module, and
a second housing (2) removably hooking to said open side of said first housing (1) to cover said open side, said first housing (1) being formed with a housing body (1-1) having a part install side at one side thereof and an open side at other side thereof;
**characterised in that**:
a front side of said housing body (1 - 1) has a device unit mount section (10) into which said front module is received;
said housing body (1 - 1) has a plurality of terminal block sections (13, 33 and 34) which receive a corresponding plurality of terminal blocks (5, 6, 7) which are installed from said open side of said first housing;
a rear side of said housing body (1- 1) has a rail engagement portion (42) for removable engagement with a rail member;
said housing body (1 - 1) has a plurality of support pillar engagement sections (21, 21-1, 36, 37, 38); and
said second housing has a plurality of engagement pillars (52 to 56) removably engaged with said support pillar engagement sections (21, 21-1, 36, 37, 38).

2. A control device according to claim 1 in which said device unit mount section (10) has a side portion extending from said housing body of said first housing (1) and hook means formed on upper and lower edges of said side portion for removably hooking to said front module (8), and said terminal block mount section (13, 33 and 34) includes a hold wall construction having at its external side a lead wire derive portion (14B) and at its front side a terminal block exposure window (32, 32-1 and 32-2), said hold wall construction having hooks removably hooking to said terminal block (5, 6 and 7).

3. A control device according to claim 2 in which an axis passing through the centre of said terminal block expose window (32, 32-1 and 32-2) is inclined relative to the axis passing through the centre of said device unit mount section (10).

4. A control device according to claim 2 in which there is a support pillar portion (14C, 14C-1 and 14C-2) on a portion of said hold wall construction of said terminal block mount section (13, 33 and 34), said support pillar portion (14C, 14C-1 and 14C-2) providing an engagement groove portion (18, 18-1 and 18-2) having an open portion passing through one end face of said support pillar portion and being open toward one wall side of said support pillar portion, and said housing body of said second housing (2) has an engagement portion inserted into said engagement groove portion (18, 18-1 and 18-2).

5. A control device according to claim 1, having a slide element (132, 133, 137 and 138) on said front module (8) contacting a conductive pattern on a printed circuit board (83), and an engagement portion removably engaging said front module (8) to said module mount section (10).

6. A control device according to claim 5 in which said front module includes a switch and a mode select switch in each having a knob on the main body of each of said switches, the switches extend to a switch base member (81) for a rotational movement, the ends of said switches being mounted by slide elements, said switch base member (81) is mounted adjacent a front cover member (82) so that portions of said switches penetrate through said front cover member (82) to be exposed, and said switch base member (81) is mounted adjacent the printed circuit board (83) so that said slide element (132, 133, 137 and 138) is pressed to contact the conductive pattern on the printed circuit board (83).

7. A control device according to claim 5 in which said engagement portion includes one engagement portion on said module mount section (10) of said first housing (1) and on a position of said second housing (2) opposing to said module mount section (10), and another engagement portion on said front module (8) removably engaged with said one engagement portion.

8. A control device construction according to claim 6 in which an optical guide portion (92A and 92B) is formed on said switch base member (81), one end of said optical guide portion (92A and 92B) being inserted into a display window (108A and 108B) on said front cover, and light projected from a light source (128A and 128B) on said printed circuit board (83) is exposed at said display window (108A and 108B) through said optical guide portion (92A and 92B).

## Patentansprüche

1. Steuervorrichtung, umfassend:
ein erstes Gehäuse (1) mit einer Installationsseite für Teile an einer Seite desselben und einer offenen Seite an der anderen Seite desselben, sodass die Installation von Teilen von der Installationsseite für Teile hin zur offenen Seite durchführbar ist,
ein Front-Modul (8), das von der offenen Seite des ersten Gehäuses (1) zur Installationsseite für Teile hin installiert ist,
eine Platteneinheit (9), die an der offenen Seite befestigt ist, um mit dem Front-Modul verbunden zu sein, und
ein zweites Gehäuse (2), das abnehmbar an der offenen Seite des ersten Gehäuses (1) zur Abdeckung der offenen Seite eingehakt ist, wobei das erste Gehäuse (1) aus einem Gehäusekörper (1 - 1) mit einer Installationsseite für Teile an einer Seite desselben und einer offenen Seite an der anderen Seite desselben gebildet ist;
**dadurch gekennzeichnet, dass**:
eine Front-Seite des Gehäusekörpers (1 - 1) einen Vorrichtungseinheit-Befestigungsabschnitt (10) aufweist, in dem das Front-Modul aufgenommen ist;
wobei der Gehäusekörper (1 - 1) eine Vielzahl von Klemmleistenbereichen (13, 33 und 34) aufweist, welche eine entsprechende Vielzahl von Klemmleisten (5, 6, 7) aufnehmen, die von der offenen Seite des ersten Gehäuses aus installiert sind;
wobei eine Rückseite des Gehäusekörpers (1 - 1) einen Schienen-Eingriffsabschnitt (42) zum lösbaren Eingriff in ein Schienenelement aufweist;
wobei der Gehäusekörper (1 - 1) eine Vielzahl an Halterungsstift-Eingriffsbereichen (21, 21 - 1, 36, 37, 38) aufweist; und
das zweite Gehäuse eine Vielzahl an Halterungsstiften (52 bis 56) aufweist, die lösbar in die Halterungsstift-Engriffsbereiche (21, 21 - 1, 36, 37, 38) eingreifen.

2. Steuervorrichtung nach Anspruch 1, in der der Vorrichtungs-Befestigungsabschnitt (10) einen Seitenabschnitt, der sich vom Gehäusekörper des ersten Gehäuses (1) aus erstreckt, und an den oberen und unteren Kanten des Seitenabschnitts ausgebildete Einhakmittel zum lösbaren Einhaken in das Front-Modul (8) aufweist, und der Klemmleisten-Befestigungsbereich (13, 33 und 34) eine Halterungswandkonstruktion mit einem Anschlussdraht-Abzweigbereich (14B) an ihrer Außenseite und einem Klemmleisten-Sichtfenster (32, 32 - 1, 32 - 2) an ihrer Front-Seite aufweist, wobei die Halterungswandkonstruktion über Haken zum lösbaren Einhaken in die Klemmleiste (5, 6 und 7) verfügt.

3. Steuervorrichtung nach Anspruch 2, in der eine Achse, die durch die Mitte des Klemmleisten-Sichtfensters (32, 32 - 1, 32 - 2) verläuft, relativ zu der durch die Mitte des Vorrichtungseinheit-Befestigungsabschnitt (10) verlaufenden Achse geneigt ist.

4. Steuervorrichtung nach Anspruch 2, in der sich ein Halterungsstiftabschnitt (14C, 14C - 1 und 14C - 2) auf einem Abschnitt der Halterungswandkonstruktion des Klemmleisten-Befestigungsbereichs (13, 33 und 34) befindet, wobei der Halterungsstiftabschnitt (14C, 14C - 1 und 14C - 2) einen Eingriffsnutabschnitt (18, 18 - 1 und 18 - 2) mit einem offenen Abschnitt, der durch eine Stirnfläche des Halterungsstiftabschnitts verläuft und in Richtung einer Wandseite des Halterungsstiftabschnitts offen ist, aufweist, und der Gehäusekörper des zweiten Gehäuses (2) einen in den Eingriffsnutabschnitt (18, 18 - 1 und 18 - 2) eingeführten Eingriffsabschnitt aufweist.

5. Steuervorrichtung nach Anspruch 1 mit einem Gleitelement (132, 133, 137 und 138) auf dem Front-Modul (8), das ein Leiterbild auf einer Leiterplatte (83) kontaktiert, und einem Eingriffsbereich zum lösbaren Eingreifen des Front-Moduls (8) in den Modul-Befestigungsbereich (10).

6. Steuervorrichtung nach Anspruch 5, in der das Front-Modul einen Schalter und einen Betriebsartenwahlschalter umfasst, wobei jeder über einen Knopf auf dem Hauptkörper jedes Schalters verfügt und die Schalter sich zu einem Schalter-Basiselement (81) für eine Drehbewegung hin erstrecken, wobei die Enden der Schalter durch Gleitelemente befestigt sind und das Schalter-Basiselement (81) angrenzend an ein Front-Abdeckungselement (82) befestigt ist, sodass die Abschnitte der Schalter durch das Front-Abdeckungselement (82) hindurchtreten um freiliegend zu sein, und das Schalter-Basiselement (81) angrenzend an die Leiterplatte (83) angebracht ist, sodass das Gleitelement (132, 133, 137 und 138) gedrückt wird, um das Leiterbild auf der Leiterplatte (83) zu kontaktieren.

7. Steuervorrichtung nach Anspruch 5, in der der Eingriffsabschnitt einen Eingriffsabschnitt am Modul-Befestigungsbereich (10) des ersten Gehäuses (1) und an einer dem Modul-Befestigungsbereich (10) gegenüberliegenden Stelle des zweiten Gehäuses (2) sowie einen weiteren Eingriffsabschnitt am Front-Modul (8) zum lösbaren Ineinandergreifen mit dem einen Eingriffsabschnitt umfasst.

8. Steuervorrichtung nach Anspruch 6, in der ein Lichtleiterabschnitt (92A und 92B) am Schalter-Basiselement (81) ausgebildet ist, wobei ein Ende des Lichtleiterabschnitts (92A und 92B) in ein Anzeigefenster (108A und 108B) auf der Front-Abdeckung eingeführt ist und das Anzeigefenster (108A und 108B) mit von einer Lichtquelle (128A und 128B) auf der Leiterplatte (83) ausgestrahltem Licht durch den Lichtleiterabschnitt (92A und 92B) beleuchtet wird.

## Revendications

1. Dispositif de commande comprenant :
un premier logement (1) comprenant un côté d'installation de pièce au niveau d'un côté de celui-ci et un côté ouvert au niveau de l'autre côté de celui-ci de sorte que l'installation de pièces peut être réalisée depuis ledit côté d'installation de pièce vers ledit côté ouvert,
un module avant (8) qui est installé depuis ledit côté ouvert dudit premier logement (1) vers ledit côté d'installation de pièce,
une unité de circuit (9) qui est montée sur ledit côté ouvert pour être raccordée audit module avant, et
un deuxième logement (2) s'accrochant de manière amovible audit côté ouvert dudit logement (1) pour couvrir ledit côté ouvert, ledit premier logement (1) étant formé avec un corps de logement (1 -1) comprenant un côté d'installation de pièce au niveau d'un côté de celui-ci et un côté ouvert au niveau de l'autre côté de celui-ci ;
**caractérisé en ce que**
un côté avant dudit corps de logement (1-1) présente une section de support d'unité de dispositif (10) dans lequel ledit module avant est reçu ;
ledit corps de logement (1-1) comprend une pluralité de sections de bloc de jonction (13, 33 et 34) qui reçoivent une pluralité correspondante de blocs de jonction (5, 6, 7) qui sont installés depuis ledit côté ouvert dudit premier logement ;
un côté arrière dudit corps de logement (1-1) comprend une partie d'enclenchement de glissière (42) pour un enclenchement amovible avec un élément de glissière ;
ledit corps de logement (1-1) comprend une pluralité de sections d'enclenchement de pilier de support (21, 21-1, 36, 37, 38) ; et
ledit deuxième logement comprend une pluralité de piliers d'enclenchement (52 à 56) enclenchés de manière amovible avec lesdites sections d'enclenchement de pilier de support (21, 21-1, 36, 37, 38).

2. Dispositif de commande selon la revendication 1, dans lequel ladite section de support d'unité de dispositif (10) comprend une partie latérale s'étendant depuis ledit corps de logement dudit premier logement (1) et des moyens formant crochet formés sur des bords supérieur et inférieur de ladite partie latérale pour s'accrocher de manière amovible audit module avant (8), et ladite section de support de bloc de jonction (13, 33 et 34) comprend une construction de paroi de retenue compr enant, au niveau de son côté externe, une partie de dérivation de fil de sortie (14B) et au niveau de son côté avant une fenêtre d'exposition de bloc de jonction (32, 32-1 et 32 -2), ladite construction de paroi de retenue comprenant des crochets s'accrochant de manière amovible audit bloc de jonction (5, 6 et 7).

3. Dispositif de commande selon la revendication 2, dans lequel un axe passant à travers le centre de ladite fenêtre d'exposition de bloc de jonction (32, 32-1 et 32 -2) est incliné par rapport à l'axe passant à travers le centre de ladite section de support d'unité de dispositif (10).

4. Dispositif de commande selon la revendication 2, dans lequel il existe une partie de pilier de support (14C, 14C-1 et 14C-2) sur une partie de ladite construction de paroi de retenue de ladite section de support de bloc de jonction (13, 33 et 34), ladite partie de pilier de support (14C, 14C - 1 et 14C - 2) fournissant une partie de rainure d'enclenchement (18, 18 - 1 et 18 -2) comprenant une partie ouverte passant à travers une face d'extrémité de ladite partie de pilier de support et étant ouverte vers un côté de paroi de ladite partie de pilier de support, et ledit corps de logement dudit deuxième logement (2) comprend une partie d'enclenchement insérée dans ladite partie de rainure d'enclenchement (18, 18-1 et 18-2).

5. Dispositif de commande selon la revendication 1, comprenant un élément de glissière (132, 133, 137 et 138) sur ledit module avant (8) entrant en contact avec un motif conducteur sur une carte de circuits imprimés (83), et une partie d'enclenchement qui enclenche de manière amovible ledit module avant (8) avec ladite section de support de module (10).

6. Dispositif de commande selon la revendication 5, dans lequel ledit module avant comprend un commu tateur et un commutateur de sélection de mode dans chacun comprenant un bouton sur le corps principal de chacun des commutateurs, les commutateurs s'étendent vers un élément de base de commutateur (81) pour un mouvement rotatif, les extrémités desdits commutateurs étant fixés par des éléments de glissière, ledit élément de base de commutateur (81) est fixé adjacent à un élément de capot avant (82) de sorte que des parties desdits commutateurs pénètrent à travers ledit élément de capot avant (82) pour être exposées, et ledit élément de base de commutateur (81) est fixé adjacent à la carte de circuits imprimés (83) de sorte que ledit élément de glissière (132, 133, 137 et 138) est enfoncé pour entrer en contact avec le motif conducteur sur la carte de circuits imprimés (83).

7. Dispositif de commande selon la revendication 5, dans lequel ladite partie d'enclenchement comprend une partie d'enclenchement sur ladite section de support de module (10) dudit premier logement (1) et sur une position dudit deuxième logement (2) opposée à ladite section de support de module (10) et une autre partie d'enclenchement sur ledit module avant (8) enclenchée de manière amovible avec ladite une partie d'enclenchement.

8. Construction de dispositif de commande selon la revendication 6 dans laquelle une partie de guidage optique (92A et 92B) est formée sur ledit élément de base de commutateur (81), une extrémité de ladite partie de guidage optique (92A et 92B) étant insérée dans une fenêtre d'affichage (108A et 108B) sur ledit capot avant, et une lumière projetée depuis une source de lumière (128A et 128B) sur ladite carte de circuits imprimés (83) est exposée au niveau de ladite fenêtre d'affichage (108A et 108B) à travers ladite partie de guidage optique (92A et 92B).
